# EUROPEAN PATENT APPLICATION

(11) **EP 1 555 305 A1**
(43) Date of publication of application: **20.07.2005**
(21) Application number: 03754133.1
(22) Date of filing: 15.10.2003
(51) Int. Cl.: C09K 11/06, H05B 33/14

(54) **MATERIAL FOR ORGANIC ELECTROLUMINESCENCE ELEMENT, AND ORGANIC ELECTROLUMINESCENCE ELEMENT USING THE SAME**

(30) Priority: 21.10.2002 JP 2002305375
(71) Applicant: IDEMITSU KOSAN CO., LTD., Tokyo 100-8321 (JP)
(72) Inventor: TOMITA, Seiji, Chiba 299-0205 (JP); IWAKUMA, Toshihiro, Chiba 299-0205 (JP); ARAKANE, Takashi, Chiba 299-0205 (JP); YASUDA, Hiroya, Chiba 299-0205 (JP); HOSOKAWA, Chishio, Chiba 299-0205 (JP)
(74) Representative: Gille, Struck, Neidlein, Prop, Roos
(86) International application number: PCT/JP2003/013186
(87) International publication number: WO 2004/035709

(57) **Abstract**

A material for an organic electroluminescence (EL) element comprising a compound with a specific condensed ring structure having a nitrogen atom; and an organic EL element which comprises a cathode, an anode and, sandwiched between them, one or more of organic thin film layers, wherein at least one organic thin film layer is an organic EL layer containing the above material for an organic EL element. The material for an organic EL element can provide an organic EL element being capable of achieving high current efficiency with a low electric voltage.

## Description

### TECHNICAL FIELD

The present invention relates to materials for organic electroluminescence element (an organic electroluminescence element will be referred to as an organic electroluminescence device, hereinafter), and organic electroluminescence element made by using the same, and more particularly to materials for organic electroluminescence devices ("electroluminescence" will be referred to as "EL", hereinafter) which exhibit a high current efficiency even when applying a low voltage thereto, and emit a blue light, and electroluminescence devices (organic EL devices) made by using the same.

### BACKGROUND ART

The organic EL devices made by using organic substances have been expected to be applied to production of full-color wide screen image display devices of a solid state light emission type at reasonable prices, and have been intensively developed. In general, the organic EL devices are constituted from a light emitting layer and a pair of counter electrodes between which the light emitting layer is sandwiched.

In the organic EL devices, when an electric field is applied between the electrodes, electrons are injected into the light emitting layer from a cathode, whereas holes are injected into the light emitting layer from an anode. The electrons and holes injected are recombined in the light emitting layer, so that the light emitting layer is brought into a excited state. When the light emitting layer is returned from the excited state to a ground state, an energy is released in the form of light.

As the light emitting materials, chelate complexes such as tris(8-quinolinolato)aluminum complexes, cumarin derivatives, tetraphenyl butadiene derivatives, bisstyrylarylene derivatives and oxadiazole derivatives are known. It is reported that light in the visible region ranging from blue light to red light can be obtained by using these light emitting materials, and development of a device exhibiting color images is expected (for example, Japanese Unexamined Patent Application Laid-Open Nos. Heissei 8(1996)-239665, Heisei 7(1995)-138561 and Heisei 3(1991)-200289, etc.).

Recently, although displays using the organic EL devices have now been used in practical applications, full-color image display devices using the same are still in the course of development. Therefore, it has been demanded to develop organic EL devices having especially a high current efficiency as well as a long lifetime.

To overcome these problems, for example, Japanese Unexamined Patent Application Laid-Open No. 2002-100476 discloses devices having a light emitting layer containing a phosphorescent compound and an electron transporting material composed of an azole compound, but does not specifically describe a current efficiency, luminance and lifetime thereof. Therefore, it is not sure whether these devices are practically usable or not.

### DISCLOSURE OF THE INVENTION

The present invention has been made to overcome the above problems. An object of the present invention is to provide materials for organic EL devices having a high current efficiency, and organic EL devices utilizing the materials.

As a result of extensive researches for accomplishing the above object, the inventors have found that organic EL devices made by using as a material therefor, a compound with a specific condensed ring structure having a nitrogen atom are capable of exhibiting a high current efficiency even upon applying a low electric voltage thereto. The present invention has been accomplished on the basis of the above finding.

Thus, the present invention provides a material for organic electroluminescent devices, comprising a compound represented by the following general formula (1): 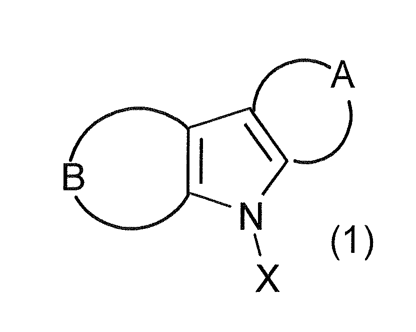 wherein A represents an alkylene group having 3 to 6 carbon atoms or an aminoalkylene group having 2 to 5 carbon atoms and containing at least one secondary or tertiary nitrogen atom, and the carbon atoms and nitrogen atom constituting a cyclic structure formed by the group represented by A may have any substituent groups;

B represents a conjugated unsaturated chain containing three kinds of atoms including carbon, hydrogen and nitrogen or two kinds of atoms including carbon and hydrogen, and the carbon atoms constituting a cyclic structure formed by the group represented by B may have any substituent groups; and

X is represented by L, L-Y or Y-L-Y wherein L is a group directly bonded to N. L represents a substituted or unsubstituted aryl group having 6 to 40 carbon atoms, a substituted or unsubstituted heterocyclic group having 3 to 40 carbon atoms, a linear or branched and substituted or unsubstituted alkyl group having 1 to 30 carbon atoms, a substituted or unsubstituted cycloalkyl group having 5 to 40 carbon atoms, a substituted or unsubstituted arylene group having 6 to 40 carbon atoms, a substituted or unsubstituted di- or more valent heterocyclic group having 3 to 40 carbon atoms, a linear or branched and substituted or unsubstituted alkylene group having 1 to 30 carbon atoms, or a substituted or unsubstituted cycloalkylene group having 5 to 40 carbon atoms; and Y represents a substituted or unsubstituted arylene group having 6 to 40 carbon atoms, a substituted or unsubstituted heterocyclic group having 3 to 40 carbon atoms, a linear or branched and substituted or unsubstituted alkyl group having 1 to 30 carbon atoms, or a substituted or unsubstituted cycloalkyl group having 5 to 40 carbon atoms.

Also, the present invention provides an organic EL device comprising a cathode, an anode and one or more organic thin film layers having at least a light emitting layer which are sandwiched between the cathode and the anode, said organic thin film layers comprising at least one layer containing the above material for organic EL devices. Among the organic thin film layers, the light-emitting layer, an electron transporting layer or a hole transporting layer preferably contains the above material for organic EL devices.

### BEST MODE FOR CARRYING OUT THE INVENTION

The material for organic electroluminescent devices according to the present invention comprises a compound represented by the following general formula (1):

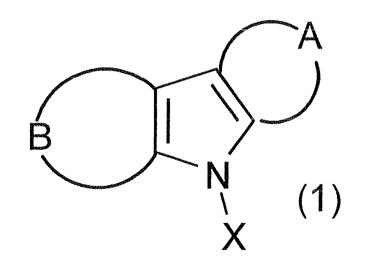

In the general formula (1), A represents an alkylene group having 3 to 6 carbon atoms or an aminoalkylene group having 2 to 5 carbon atoms and containing at least one secondary or tertiary nitrogen atom in which the carbon atoms and nitrogen atom constituting a cyclic structure formed by the group represented by A may have any substituent groups.

Examples of the alkylene group include propylene group, butylene group, pentylene group and hexylene group.

Examples of the aminoalkylene group include those groups containing -N-C-C-, -C-N-C-, -N-C-C-C-, -C-N-C-C-, -N-C-C-C-C-, -C-N-C-C-C-, -C-C-N-C-C-, -N-C-C-C-C-C-, -C-N-C-C-C-C-, and -C-C-N-C-C-C- skeletons.

Also, examples of the substituent groups which may be bonded to the carbon atoms and nitrogen atom constituting a cyclic structure formed by the group represented by A include halogen atoms such as fluorine, chlorine and bromine, cyano group, silyl group, amino group, aryl group, aryloxy group, a heterocyclic group, alkyl group, alkoxyl group, aralkyl group and cycloalkyl group.

In the general formula (1), B represents a conjugated unsaturated chain containing three kinds of atoms including carbon, hydrogen and nitrogen or two kinds of atoms including carbon and hydrogen in which the carbon atoms constituting a cyclic structure formed by the group represented by B may have any substituent groups.

Examples of the substituent groups which may be bonded to the carbon atoms constituting a cyclic structure formed by the group represented by B include halogen atoms such as fluorine, chlorine and bromine, cyano group, silyl group, amino group, aryl group, aryloxy group, a heterocyclic group, alkyl group, alkoxyl group, aralkyl group and cycloalkyl group.

In the general formula (1), X is represented by L, L-Y or Y-L-Y wherein L is a group directly bonded to N.

L represents a substituted or unsubstituted aryl group having 6 to 40 carbon atoms, a substituted or unsubstituted heterocyclic group having 3 to 40 carbon atoms, a linear or branched and substituted or unsubstituted alkyl group having 1 to 30 carbon atoms, a substituted or unsubstituted cycloalkyl group having 5 to 40 carbon atoms, a substituted or unsubstituted arylene group having 6 to 40 carbon atoms, a substituted or unsubstituted di- or more valent heterocyclic group having 3 to 40 carbon atoms, a linear or branched and substituted or unsubstituted alkylene group having 1 to 30 carbon atoms, or a substituted or unsubstituted cycloalkylene group having 5 to 40 carbon atoms.

Y represents a substituted or unsubstituted arylene group having 6 to 40 carbon atoms, a substituted or unsubstituted heterocyclic group having 3 to 40 carbon atoms, a linear or branched and substituted or unsubstituted alkyl group having 1 to 30 carbon atoms, or a substituted or unsubstituted cycloalkyl group having 5 to 40 carbon atoms.

Examples of the aryl group described above include phenyl group, 1-naphthyl group, 2-naphthyl group, 1-anthryl group, 2-anthryl group, 9-anthryl group, 1-phenathryl group, 2-phenathryl group, 3-phenathryl group, 4-phenathryl group, 9-phenathryl group, 1-naphthacenyl group, 2-naphthacenyl group, 9-naphthacenyl group, 1-pyrenyl group, 2-pyrenyl group, 4-pyrenyl group, 2-biphenylyl group, 3-biphenylyl group, 4-biphenylyl group, p-terphenyl-4-yl group, p-terphenyl-3-yl group, p-terphenyl-2-yl group, m-terphenyl-4-yl group, m-terphenyl-3-yl group, m-terphenyl-2-yl group, o-tolyl group, m-tolyl group, p-tolyl group, p-t-butylphenyl group, p-(2-phenylpropyl)phenyl group, 3-methyl-2-naphthyl group, 4-methyl-1-naphthyl group, 4-methyl-1-anthryl group, 4'-methylbiphenylyl group, 4"-t-butyl-p-terphenyl-4-yl group, fluorenyl group, perfluoroaryl group, 1,1';3',1"-terphenyl-5'-yl group, 1,1';3',1"-terphenyl-2'-yl group and 1,1';3',1"-terphenyl-4'-yl group.

Examples of the heterocyclic group represented by L include pyrrole, pyridine, pyrimidine, pyrazine, triazine, aziridine, azaindoline, indolizine, imidazole, indole, isoindole, indazole, purine, pteridine and β-carboline.

Examples of the alkyl group described above include methyl group, trifluoromethyl group, ethyl group, propyl group, isopropyl group, n-butyl group, s-butyl group, isobutyl group, t-butyl group, n-pentyl group, n-hexyl group, n-heptyl group, n-octyl group, hydroxymethyl group, 1-hydroxyethyl group, 2-hydroxyethyl group, 2-hydroxyisobutyl group, 1,2-dihydroxyethyl group, 1,3-dihydroxyisopropyl group, 2,3-dihydroxy-t-butyl group, 1,2,3-trihydroxypropyl group, chloromethyl group, 1-chloroethyl group, 2-chloroethyl group, 2-chloroisobutyl group, 1,2-dichloroethyl group, 1,3-dichloroisopropyl group, 2,3-dichloro-t-butyl group, 1,2,3-trichloropropyl group, bromomethyl group, 1-bromoethyl group, 2-bromoethyl group, 2-bromoisobutyl group, 1,2-dibromoethyl group, 1,3-dibromoisopropyl group, 2,3-dibromo-t-butyl group, 1,2,3-tribromopropyl group, iodomethyl group, 1-iodoethyl group, 2-iodoethyl group, 2-iodoisobutyl group, 1,2-diiodoethyl group, 1,3-diiodoisopropyl group, 2,3-diiodo-t-butyl group, 1,2,3-triiodopropyl group, aminomethyl group, 1-aminoethyl group, 2-aminoethyl group, 2-aminoisobutyl group, 1,2-diaminoethyl group, 1,3-diaminoisopropyl group, 2,3-diamino-t-butyl group, 1,2,3-triaminopropyl group, cyanomethyl group 1-cyanoethyl group, 2-cyanoethyl group, 2-cyanoisobutyl group, 1,2-dicyanoethyl group, 1,3-dicyanoisopropyl group, 2,3-dicyano-t-butyl group, 1,2,3-tricyanopropyl group, nitromethyl group, 1-nitroethyl group, 2-nitroethyl group, 2-nitroisobutyl group, 1,2-dinitroethyl group, 1,3-dinitroisopropyl group, 2,3-dinitro-t-butyl group and 1,2.3-trinitropropyl group.

Examples of the cycloalkyl group described above include cyclopentyl group, cyclohexyl group, 4-methyl cyclohexyl group, adamanthyl group and norbornyl group.

Examples of the arylene group described above include divalent groups derived from the above aryl groups.

Examples of the substituted or unsubstituted di or more-valent heterocyclic group having 3 to 40 carbon atoms represented by L include di or more-valent groups derived from the above heterocyclic groups.

Examples of the alkylene group described above include divalent groups derived from the above alkyl groups.

Examples of the cycloalkylene group described above include divalent groups derived from the above cycloalkyl groups.

Examples of the aryl group, heterocyclic group, alkyl group and cycloalkyl group represented by Y include the same groups as exemplified as L above, respectively.

The compound represented by the general formula (1) is preferably any of compounds represented by the following formulae (2) to (6):

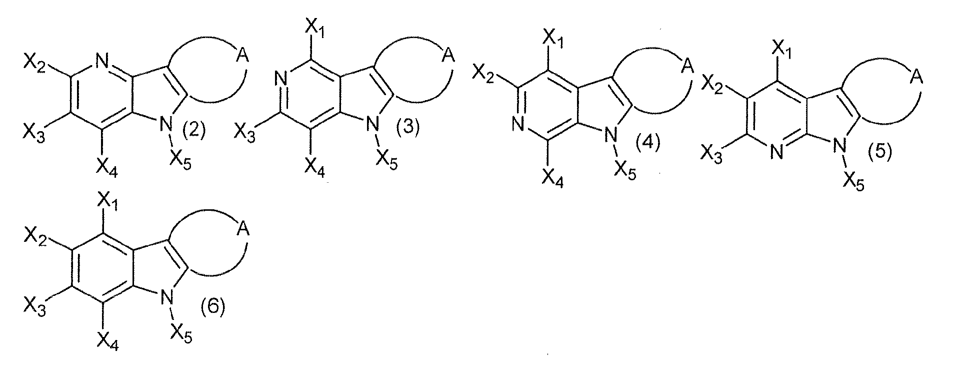

In the general formulae (2) to (6), A is the same as defined above; X₁ to X₅ independently represent a hydrogen atom, L, L-Y or Y-L-Y with the proviso that X₅ is not a hydrogen atom wherein L is a group directly bonded to N. L and Y are respectively the same as defined above.

The compound represented by the general formula (6) is preferably any of compounds represented by the following formulae (7) to (10):

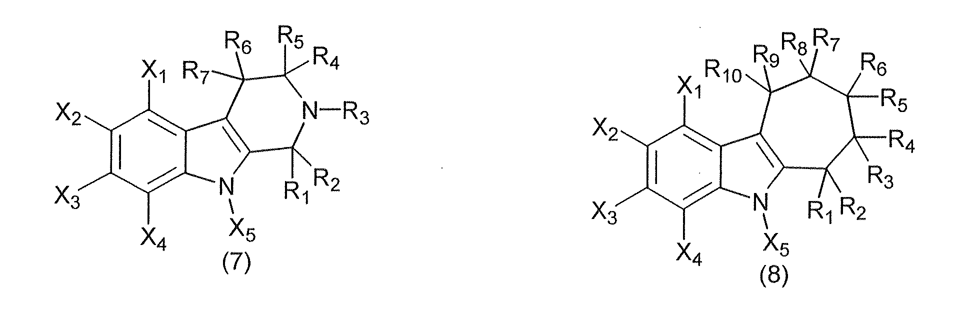

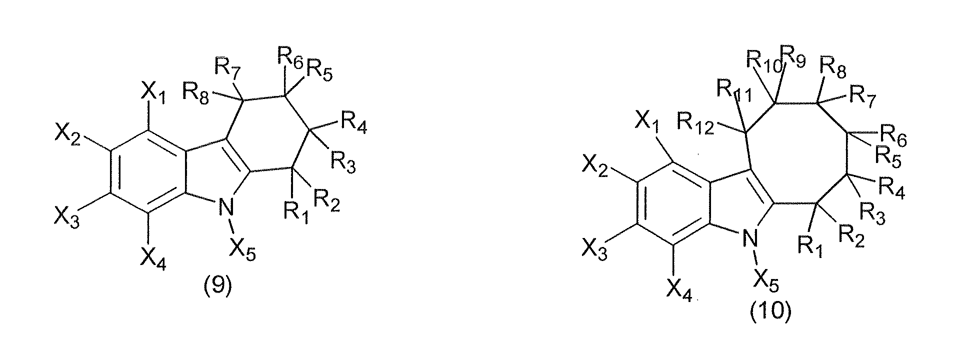

In the general formulae (7) to (10), X₁ to X₅ independently represent a hydrogen atom, L, L-Y or Y-L-Y with the proviso that X₅ is not a hydrogen atom wherein L is a group directly bonded to N. L and Y are respectively the same as defined above.

R₁ to R₁₂ independently represent a halogen atom, a cyano group, a silyl group, a substituted or unsubstituted amino group, a substituted or unsubstituted aryl group having 6 to 40 carbon atoms, a substituted or unsubstituted aryloxy group having 6 to 40 carbon atoms, a substituted or unsubstituted heterocyclic group having 3 to 40 carbon atoms, a linear or branched and substituted or unsubstituted alkyl group having 1 to 30 carbon atoms, a substituted or unsubstituted alkoxy group having 1 to 30 carbon atoms, a substituted or unsubstituted aralkyl group having 7 to 40 carbon atoms, or a substituted or unsubstituted cycloalkyl group having 5 to 40 carbon atoms.

Examples of the halogen atom represented by R₁ to R₁₂ include fluorine, chlorine, bromine and iodine.

Examples of the aryl group described above include the same aryl groups as exemplified as L above.

The aryloxy group described above is represented by the formula: -OZ. Examples of Z include phenyl group, 1-naphthyl group, 2-naphthyl group, 1-anthryl group, 2-anthryl group, 9-anthryl group, 1-phenathryl group, 2-phenathryl group, 3-phenathryl group, 4-phenathryl group, 9-phenathryl group, 1-naphthacenyl group, 2-naphthacenyl group, 9-naphthacenyl group, 1-pyrenyl group, 2-pyrenyl group, 4-pyrenyl group, 2-biphenylyl group, 3-biphenylyl group, 4-biphenylyl group, p-terphenyl-4-yl group, p-terphenyl-3-yl group, p-terphenyl-2-yl group, m-terphenyl-4-yl group, m-terphenyl-3-yl group, m-terphenyl-2-yl group, o-tolyl group, m-tolyl group, p-tolyl group, p-t-butylphenyl group, p-(2-phenylpropyl)phenyl group, 3-methyl-2-naphthyl group, 4-methyl-1-naphthyl group, 4-methyl-1-anthryl group, 4'-methylbiphenylyl group, 4"-t-butyl-p-terphenyl-4-yl group, 2-pyrrolyl group, 3-pyrrolyl group, pyradinyl group, 2-pyridinyl group, 3-pyridinyl group, 4-pyridinyl group, 2-indolyl group, 3-indolyl group, 4-indolyl group, 5-indolyl group, 6-indolyl group, 7-indolyl group, 1-isoindolyl group, 3-isoindolyl group, 4-isoindolyl group, 5-isoindolyl group, 6-isoindolyl group, 7-isoindolyl group, 2-furyl group, 3-fyryl group, 2-benzofuranyl group, 3-benzofuranyl group, 4-benzofuranyl group, 5-benzofuranyl group, 6-benzofuranyl group, 7-benzofuranyl group, 1-isobenzofuranyl group, 3-isobenzofuranyl group, 4-isobenzofuranyl group, 5-isobenzofuranyl group, 6-isobenzofuranyl group, 7-isobenzofuranyl group, 2-quinolyl group, 3-quinolyl group, 4-quinolyl group, 5-quinolyl group, 6-quinolyl group, 7-quinolyl group, 8-quinolyl group, 1-isoquinolyl group, 3-isoquinolyl group, 4-isoquinolyl group, 5-isoquinolyl group, 6-isoquinolyl group, 7-isoquinolyl group, 8-isoquinolyl group, 2-quinoxalinyl group, 5-quinoxalinyl group, 6-quinoxalinyl group, 1-carbazolyl group, 2-carbazolyl group, 3-carbazolyl group, 4-carbazolyl group, 1-phenanthridinyl group, 2-phenanthridinyl group, 3-phenanthridinyl group, 4-phenanthridinyl group, 6-phenanthridinyl group, 7-phenanthridinyl group, 8-phenanthridinyl group, 9-phenanthridinyl group, 10-phenanthridinyl group, 1-acridinyl group, 2-acridinyl group, 3-acridinyl group, 4-acridinyl group, 9-acridinyl group, 1,7-phenanthrolin-2-yl group, 1,7-phenanthrolin-3-yl group, 1,7-phenanthrolin-4-yl group, 1,7-phenanthrolin-5-yl group, 1,7-phenanthrolin-6-yl group, 1,7-phenanthrolin-8-yl group, 1,7-phenanthrolin-9-yl group, 1,7-phenanthrolin-10-yl group, 1,8-phenanthrolin-2-yl group, 1,8-phenanthrolin-3-yl group, 1,8-phenanthrolin-4-yl group, 1,8-phenanthrolin-5-yl group, 1,8-phenanthrolin-6-yl group, 1,8-phenanthrolin-7-yl group, 1,8-phenanthrolin-9-yl group, 1,8-phenanthrolin-10-yl group, 1,9-phenanthrolin-2-yl group, 1,9-phenanthrolin-3-yl group, 1,9-phenanthrolin-4-yl group, 1,9-phenanthrolin-5-yl group, 1,9-phenanthrolin-6-yl group, 1,9-phenanthrolin-7-yl group, 1,9-phenanthrolin-8-yl group, 1,9-phenanthrolin-10-yl group, 1,10-phenanthrolin-2-yl group, 1,10-phenanthrolin-3-yl group, 1,10-phenanthrolin-4-yl group, 1,10-phenanthrolin-5-yl group, 2,9-phenanthrolin-1-yl group, 2,9-phenanthrolin-3-yl group, 2,9-phenanthrolin-4-yl group, 2,9-phenanthrolin-5-yl group, 2,9-phenanthrolin-6-yl group, 2,9-phenanthrolin-7-yl group, 2,9-phenanthrolin-8-yl group, 2,9-phenanthrolin-10-yl group, 2,8-phenanthrolin-1-yl group, 2,8-phenanthrolin-3-yl group, 2,8-phenanthrolin-4-yl group, 2,8-phenanthrolin-5-yl group, 2,8-phenanthrolin-6-yl group, 2,8-phenanthrolin-7-yl group, 2,8-phenanthrolin-9-yl group, 2,8-phenanthrolin-10-yl group, 2,7-phenanthrolin-1-yl group, 2,7-phenanthrolin-3-yl group, 2,7-phenanthrolin-4-yl group, 2,7-phenanthrolin-5-yl group, 2,7-phenanthrolin-6-yl group, 2,7-phenanthrolin-8-yl group, 2,7-phenanthrolin-9-yl group, 2,7-phenanthrolin-10-yl group, 1-phenazinyl group, 2-phenazinyl group, 1-phenothiazinyl group, 2-phenothiazinyl group, 3-phenothiazinyl group, 4-phenothiazinyl group, 1-phenoxazinyl group, 2-phenoxazinyl group, 3-phenoxazinyl group, 4-phenoxazinyl group, 2-oxazolyl group, 4-oxazolyl group, 5-oxazolyl group, 2-oxadiazolyl group, 5-oxadiazolyl group, 3-furazanyl group, 2-thienyl group, 3-thienyl group, 2-methylpyrrol-1-yl group, 2-methylpyrrol-3-yl group, 2-methylpyrrol-4-yl group, 2-methylpyrrol-5-yl group, 3-methylpyrrol-1-yl group, 3-methylpyrrol-2-yl group, 3-methylpyrrol-4-yl group, 3-methylpyrrol-5-yl group, 2-t-butylpyrrol-4-yl group, 3-(2-phenylpropyl)pyrrol-1-yl group, 2-methyl-1-indolyl group, 4-methyl-1-indolyl group, 2-methyl-3-indolyl group, 4-methyl-3-indolyl group, 2-t-butyl-1-indolyl group, 4-t-butyl-1-indolyl group, 2-t-butyl-3-indolyl group and 4-t-butyl-3-indolyl group.

Examples of the heterocyclic group described above include the same heterocyclic groups as exemplified as L above.

Examples of the alkyl group described above include the same alkyl groups as exemplified as L above.

The alkoxy groups represented by R₁ to R₁₂ are groups represented by the formula:-OY¹. Examples of Y¹ include methyl group, trifluoromethyl group, ethyl group, propyl group, isopropyl group, n-butyl group, s-butyl group, isobutyl group, t-butyl group, n-pentyl group, n-hexyl group, n-heptyl group, n-octyl group, hydroxymethyl group, 1-hydroxyethyl group, 2-hydroxyethyl group, 2-hydroxyisobutyl group, 1,2-dihydroxyethyl group, 1,3-dihydroxyisopropyl group, 2,3-dihydroxy-t-butyl group, 1,2,3-trihydroxypropyl group, chloromethyl group, 1-chloroethyl group, 2-chloroethyl group, 2-chloroisobutyl group, 1,2-dichloroethyl group, 1,3-dichloroisopropyl group, 2,3-dichloro-t-butyl group, 1,2,3-trichloropropyl group, bromomethyl group, 1-bromoethyl group, 2-bromoethyl group, 2-bromoisobutyl group, 1,2-dibromoethyl group, 1,3-dibromoisopropyl group, 2,3-dibromo-t-butyl group, 1,2,3-tribromopropyl group, iodomethyl group, 1-iodoethyl group, 2-iodoethyl group, 2-iodoisobutyl group, 1,2-diiodoethyl group, 1,3-diiodoisopropyl group, 2,3-diiodo-t-butyl group, 1,2,3-triiodopropyl group, aminomethyl group, 1-aminoethyl group, 2-aminoethyl group, 2-aminoisobutyl group, 1,2-diaminoethyl group, 1,3-diaminoisopropyl group, 2,3-diamino-t-butyl group, 1,2,3-triaminopropyl group, cyanomethyl group, 1-cyanoethyl group, 2-cyanoethyl group, 2-cyanoisobutyl group, 1,2-dicyanoethyl group, 1,3-dicyanoisopropyl group, 2,3-dicyano-t-butyl group, 1,2,3-tricyanopropyl group, nitromethyl group, 1-nitroethyl group, 2-nitroethyl group, 2-nitroisobutyl group, 1,2-dinitroethyl group, 1,3-dinitroisopropyl group, 2,3-dinitro-t-butyl group and 1,2.3-trinitropropyl group.

Examples of the aralkyl group described above include benzyl group, 1-phenylethyl group, 2-phenylethyl group, 1-phenylisopropyl group, 2-phenylisopropyl group, phenyl-t-butyl group, α-naphthylmethyl group, 1-α-naphthylethyl group, 2-α-naphthylethyl group, 1-α-naphthylisopropyl group, 2-α-naphthylisopropyl group, β-naphthylmethyl group, 1-β-naphthylethyl group, 2-β-naphthylethyl group, 1-β-naphthylisopropyl group, 2-β-naphthylisopropyl group, 1-pyrrolylmethyl group, 2-(1-pyrrolyl)ethyl group, p-methylbenzyl group, m-methylbenzyl group, o-methylbenzyl group, p-chlorobenzyl group, m-chlorobenzyl group, o-chlorobenzyl group, p-bromobenzyl group, m-bromobenzyl group, o-bromobenzyl group, p-iodobenzyl group, m-iodobenzyl group, o-iodobenzyl group, p-hydroxybenzyl group, m-hydroxybenzyl group, o-hydroxybenzyl group, p-aminobenzyl group, m-aminobenzyl group, o-aminobenzyl group, p-nitrobenzyl group, m-nitrobenzyl group, o-nitrobenzyl group, p-cyanobenzyl group, m-cyanobenzyl group, o-cyanobenzyl group, 1-hydroxy-2-phenylisopropyl group, 1-chloro-2-phenylisopropyl group and trityl group.

Examples of the cycloalkyl group represented by R₁ to R₁₂ include the same cycloalkyl groups as exemplified as L above.

The compound represented by the general formula (9) is preferably any of compounds represented by the following general formulae (11) to (13):

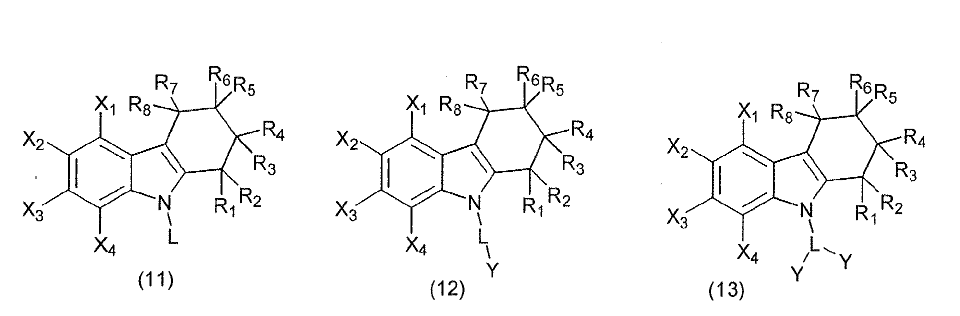

In the general formulae (11) to (13), X₁ to X₄ independently represent L, L-Y or Y-L-Y wherein L is a group directly bonded to N. L and Y are the same as defined above.

R₁ to R₈ are independently the same as defined above.

Examples of the compounds represented by the general formulae (11) to (13) which are usable as the material for organic EL devices include the following compounds, though not limited thereto.

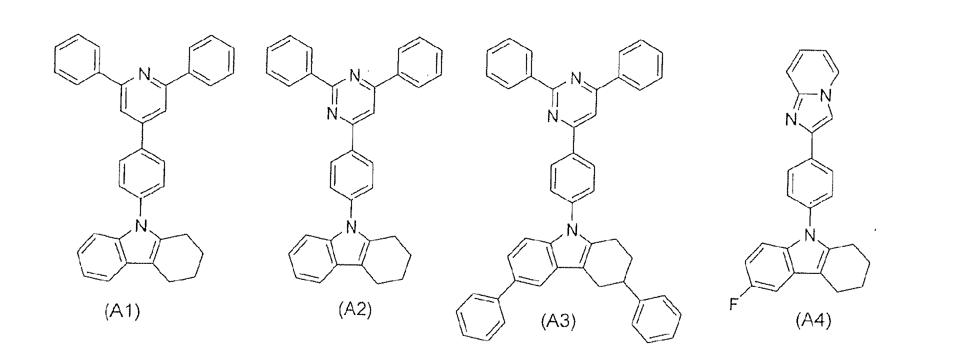

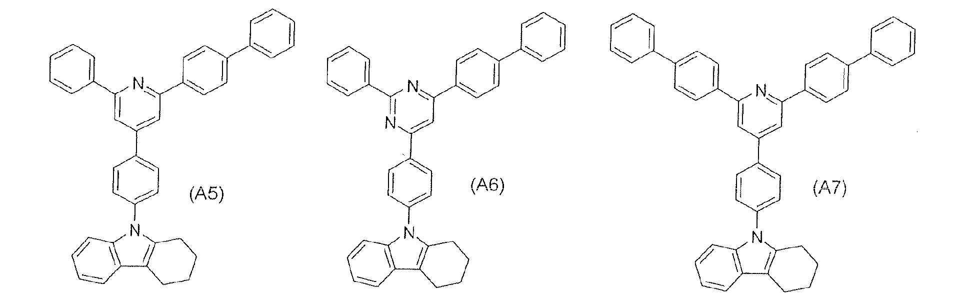

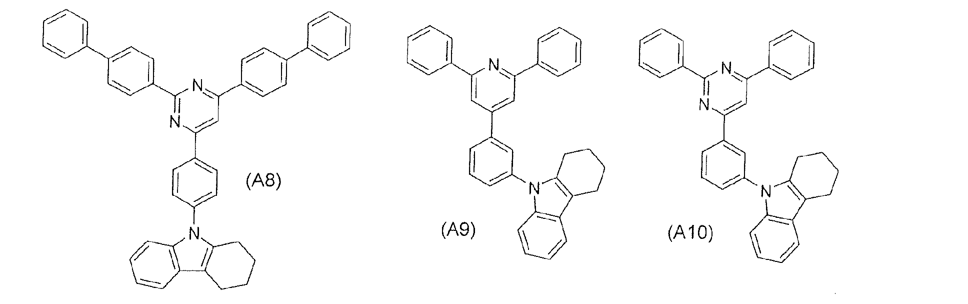

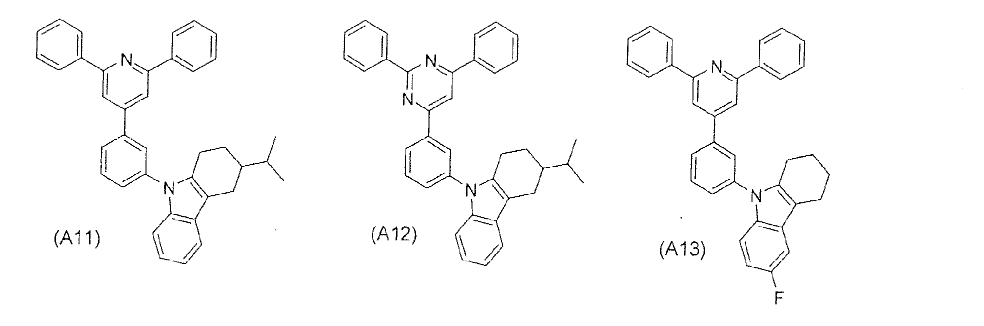

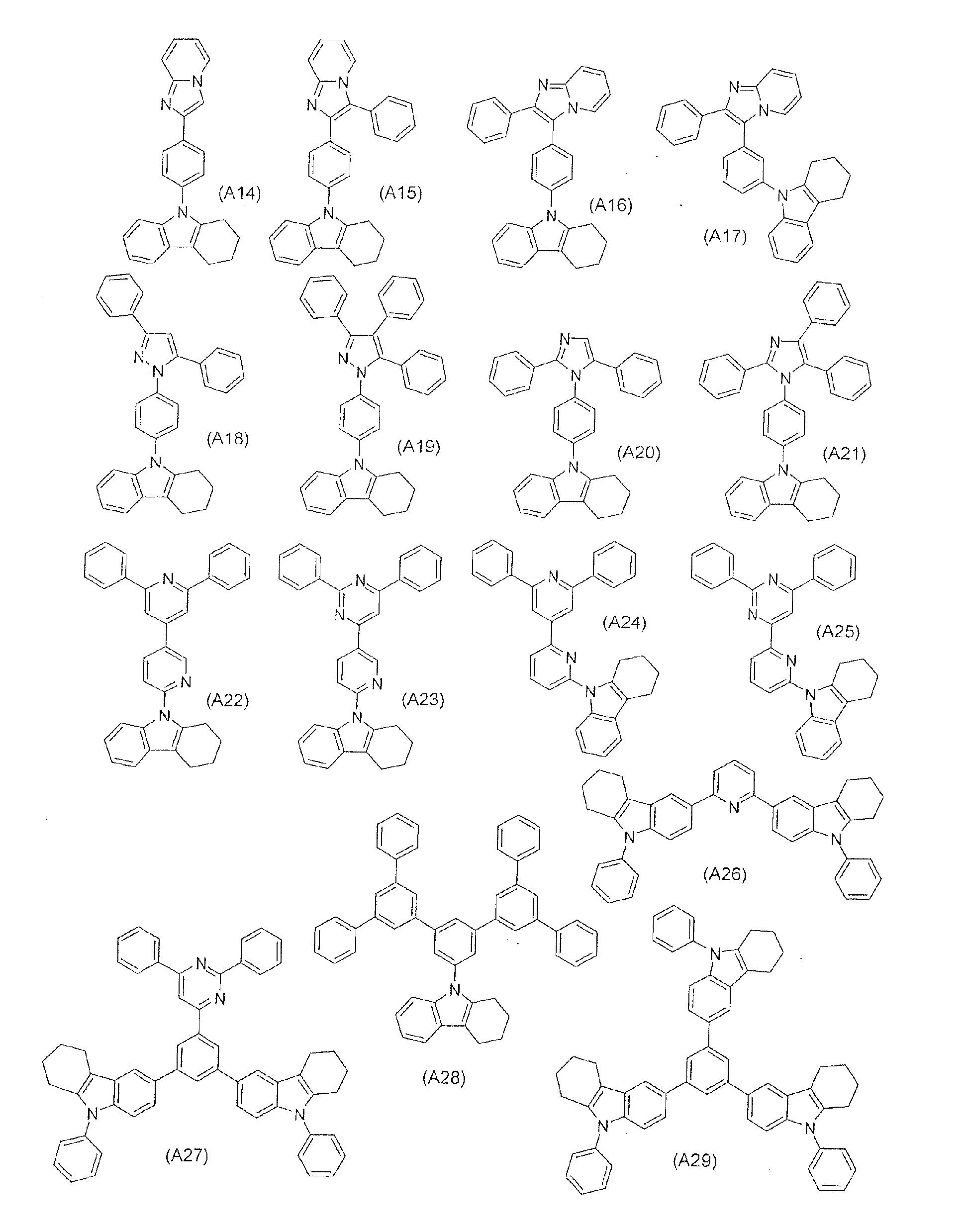

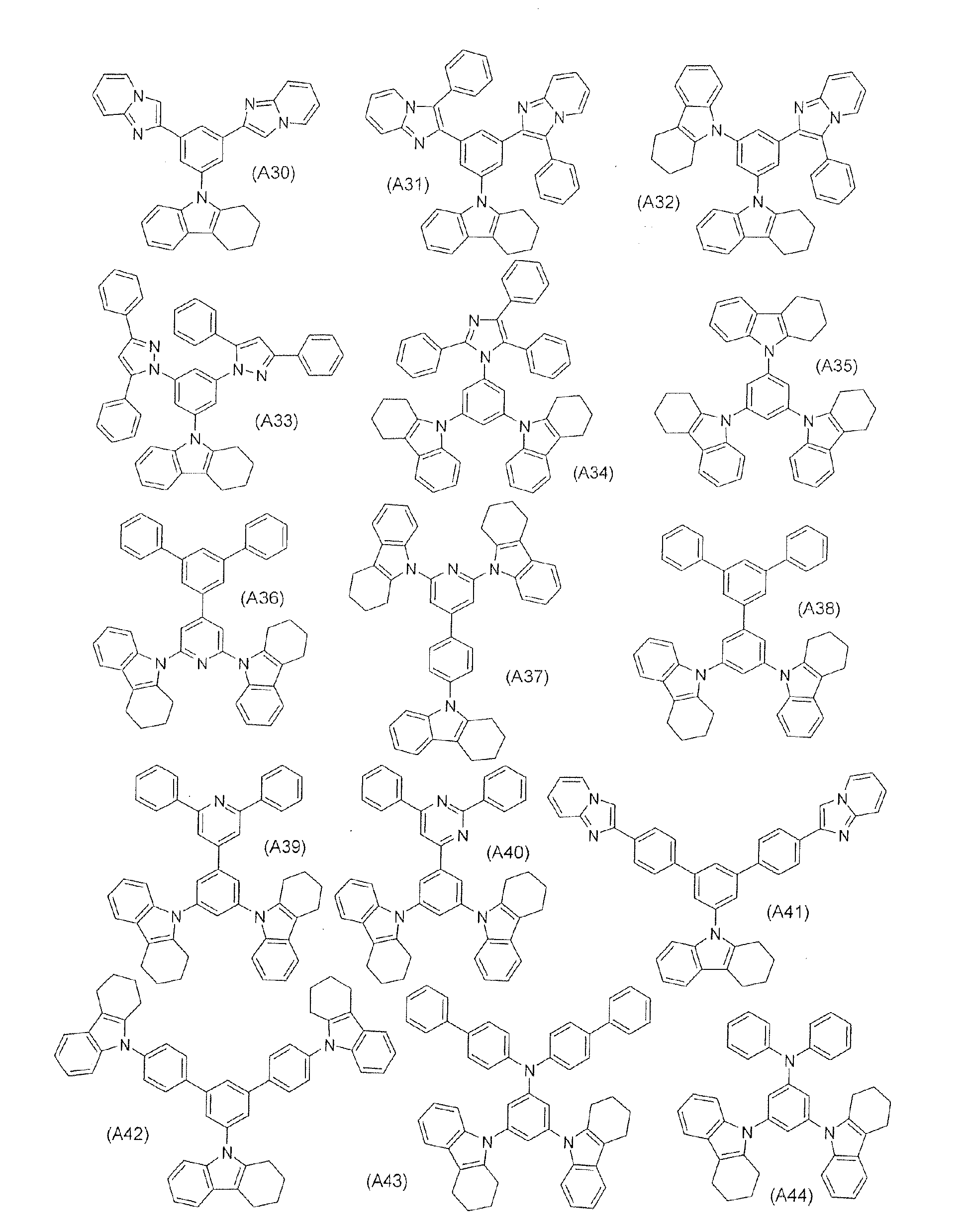

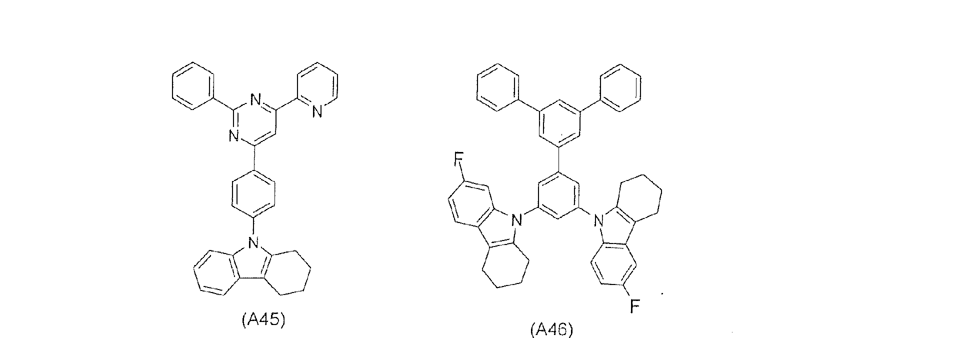

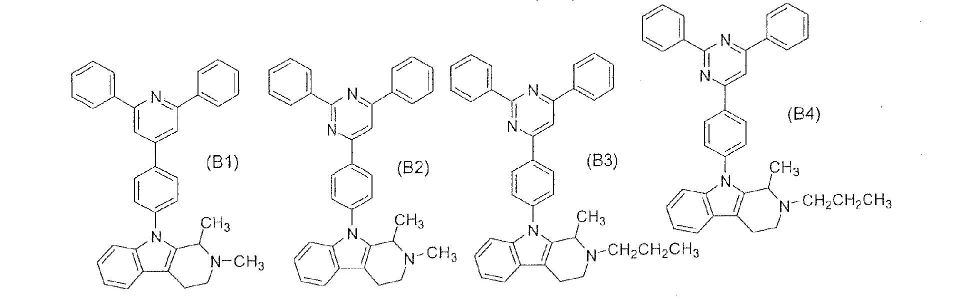

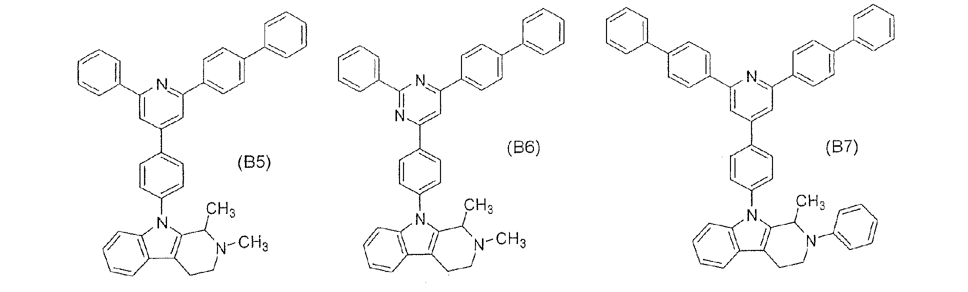

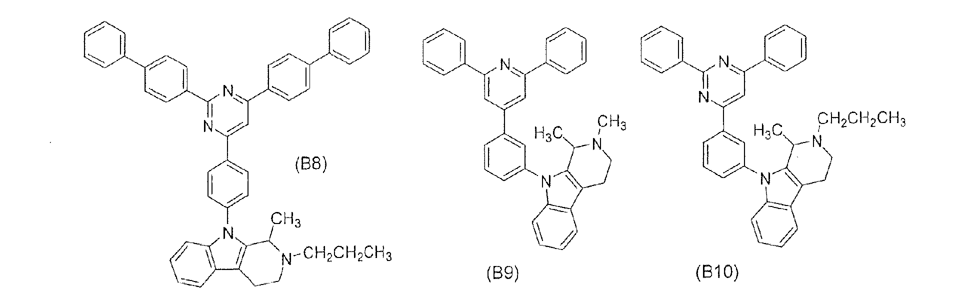

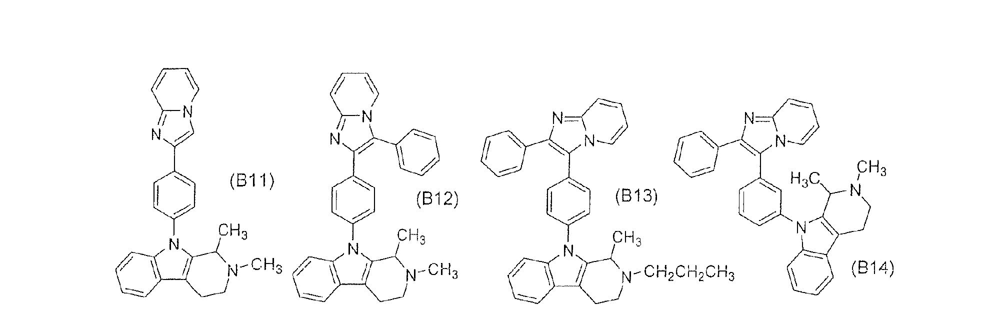

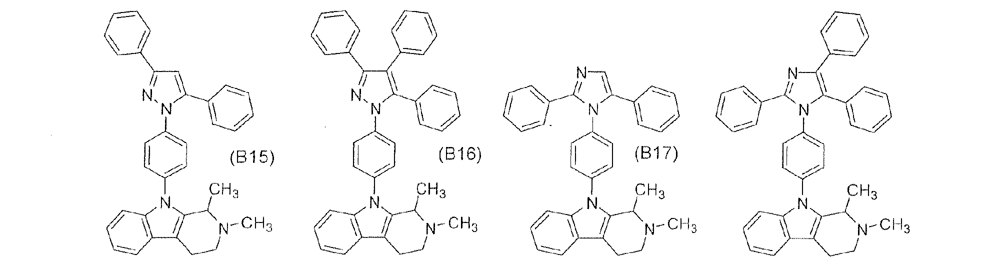

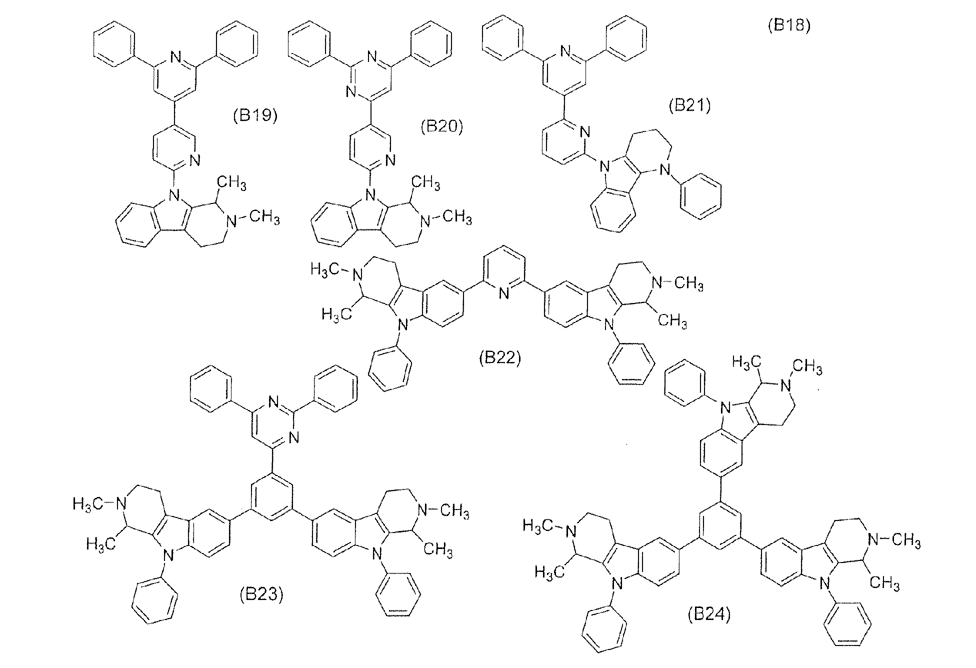

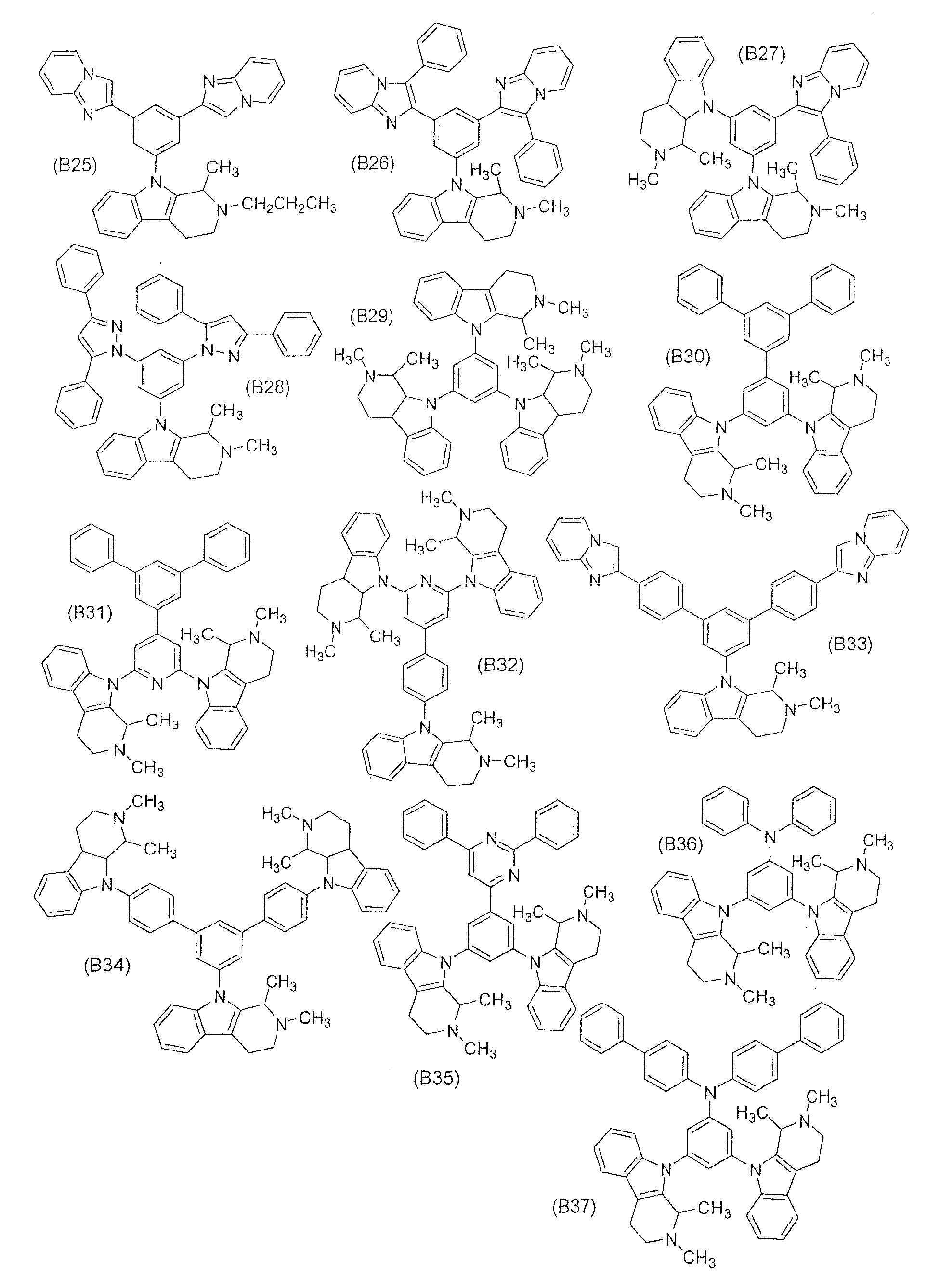

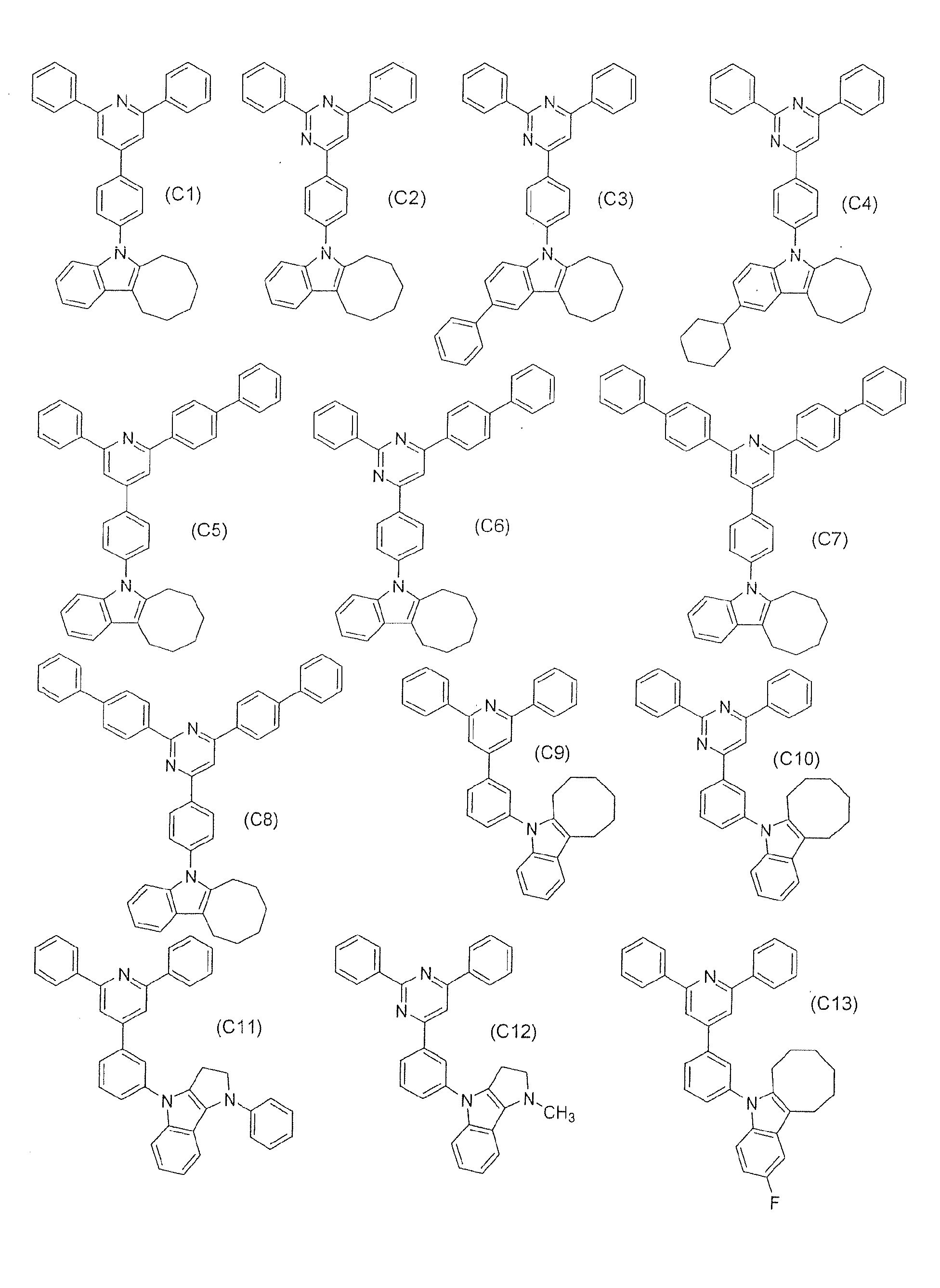

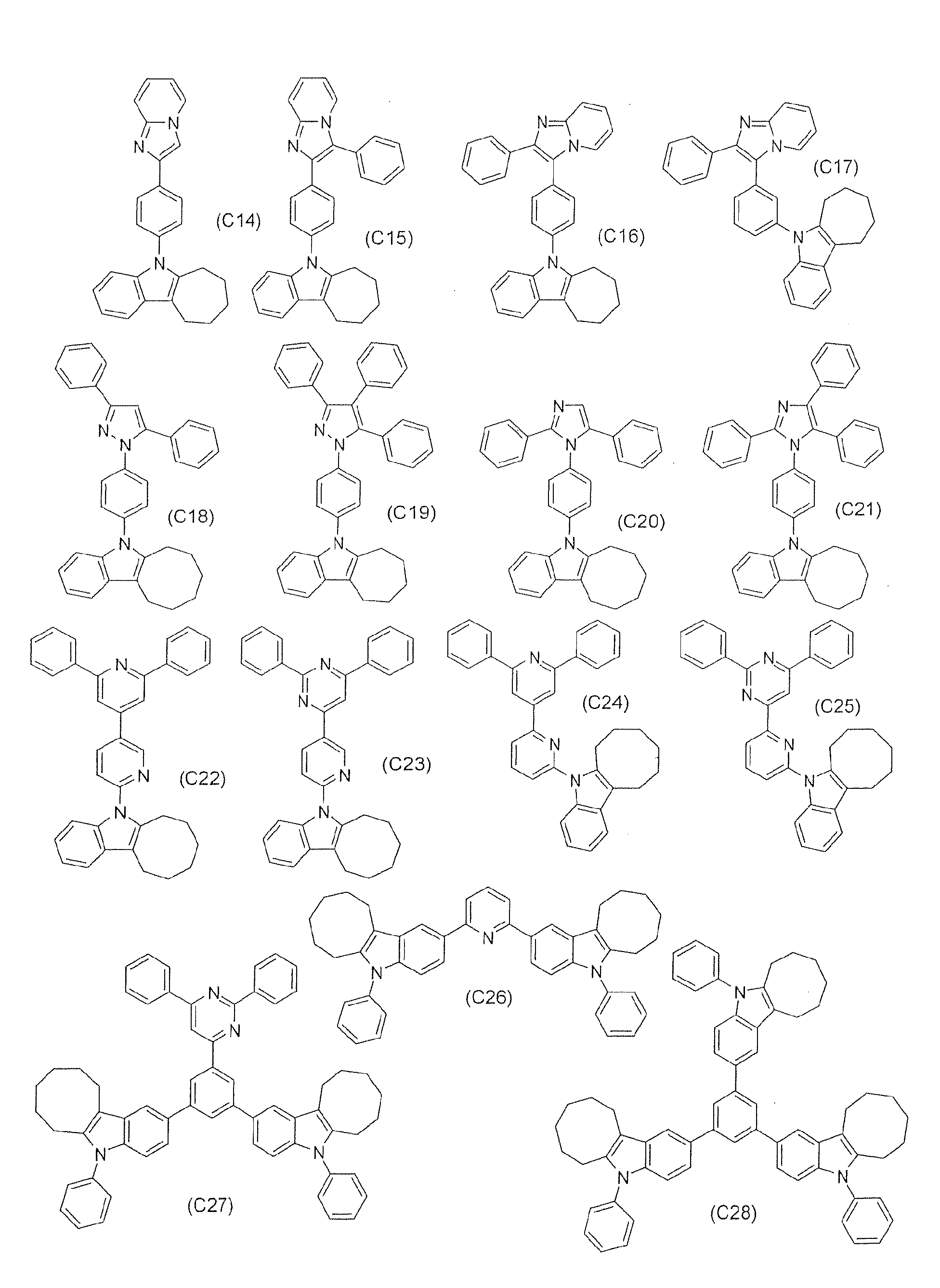

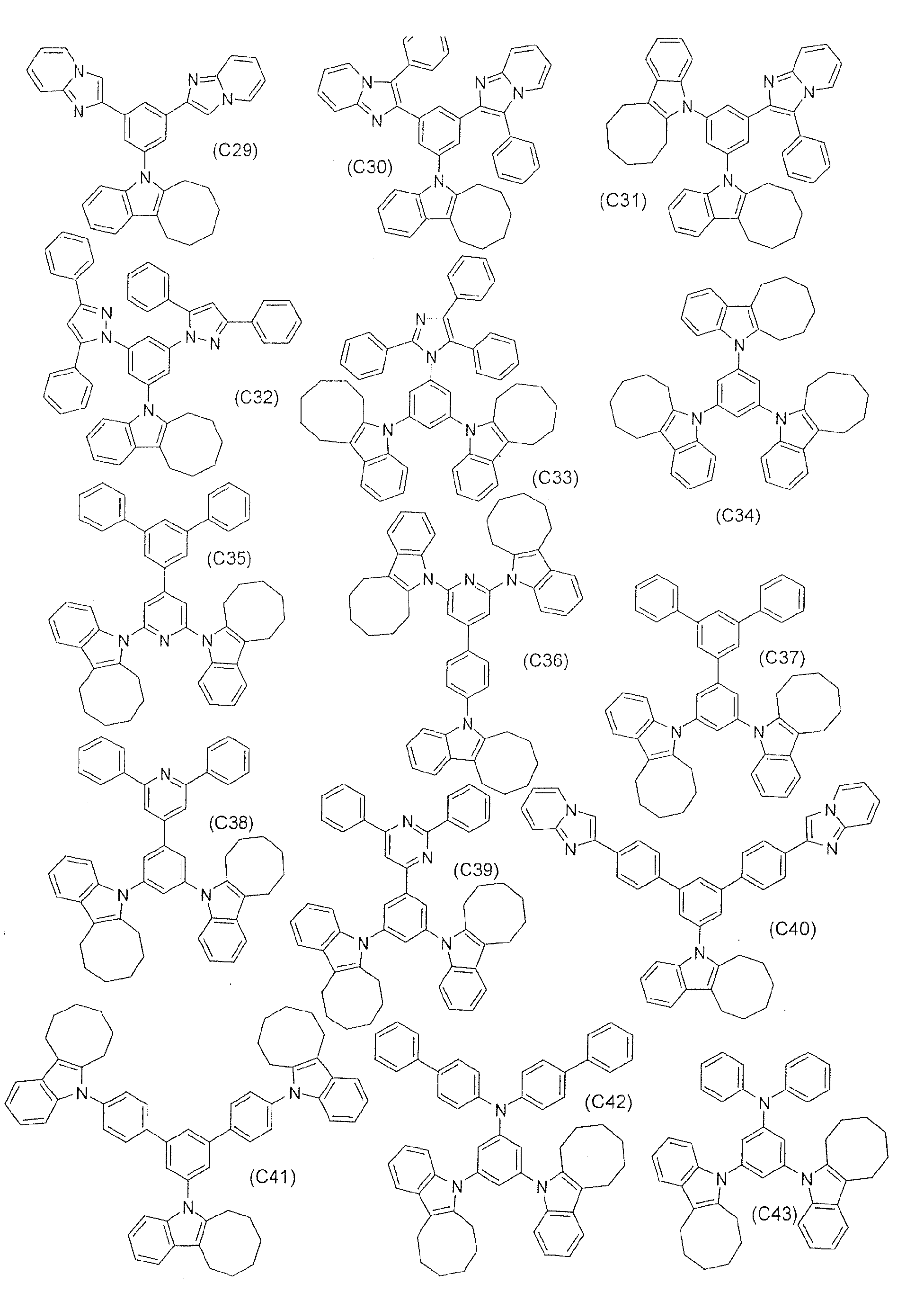

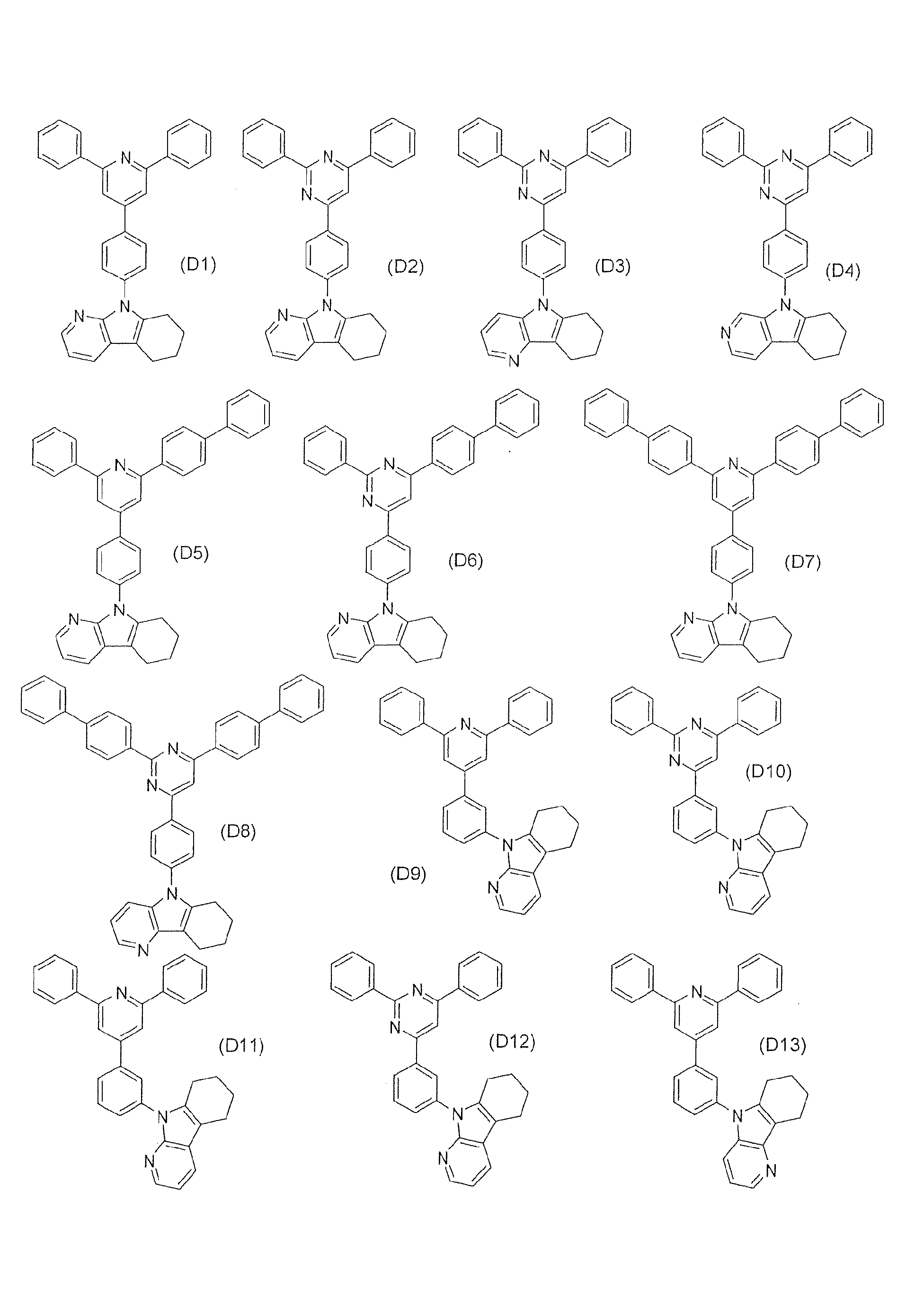

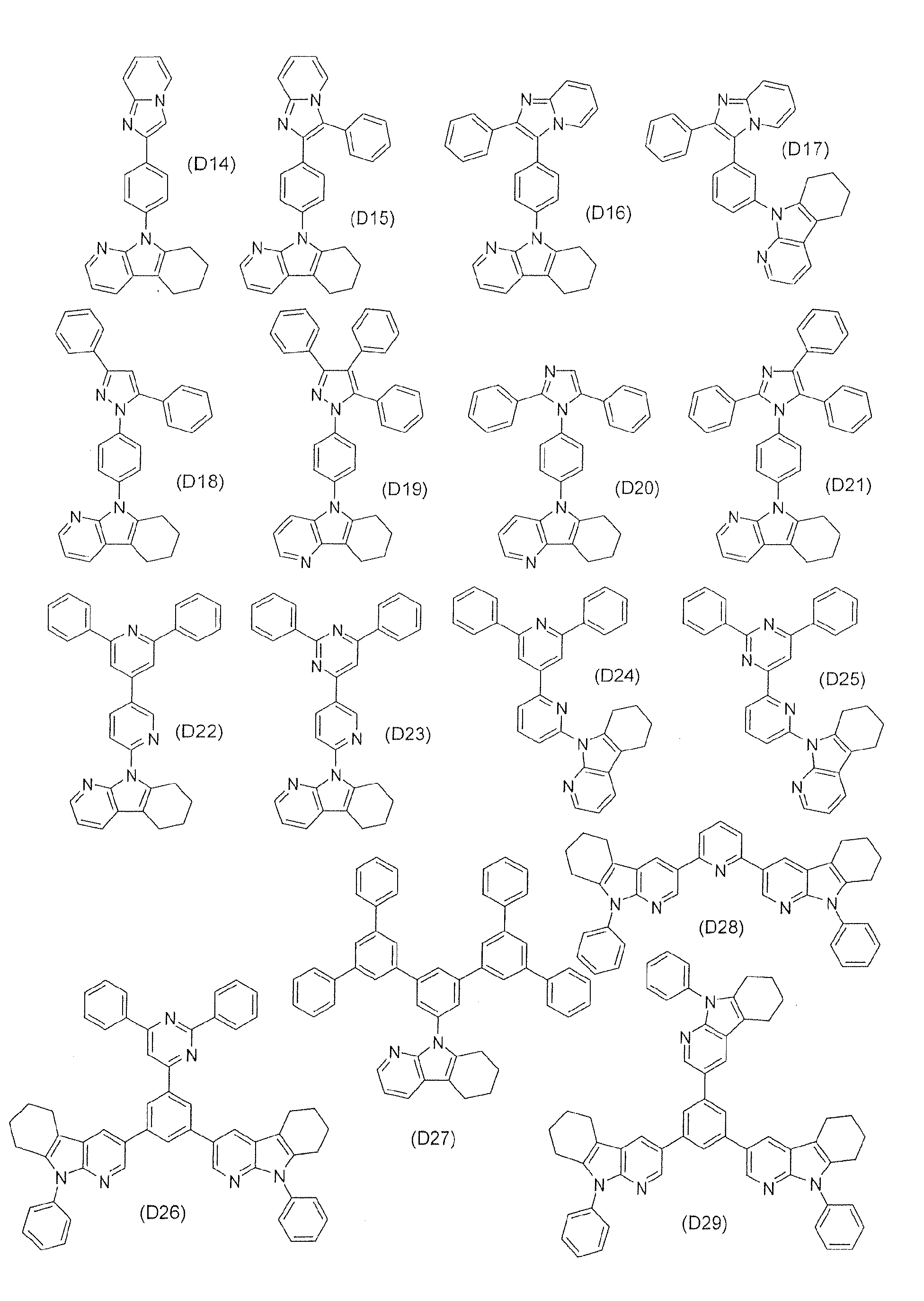

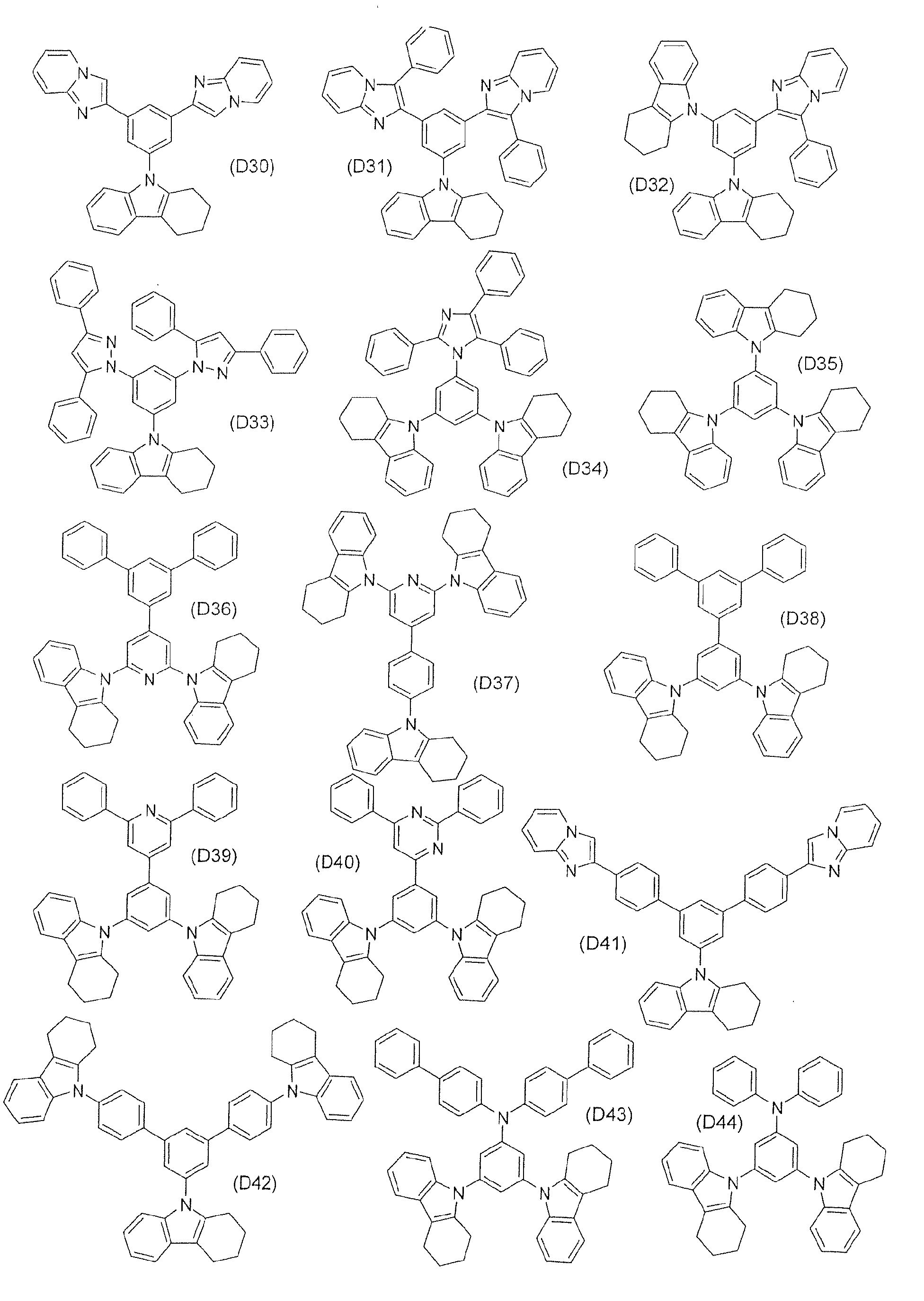

The material for organic EL devices according to the present invention which comprises any of the compounds represented by the general formulae (1) to (13) has a triplet energy gap of 2.5 to 3.3 eV and preferably 2.8 to 3.2 eV.

The material for organic EL devices according to the present invention which comprises any of the compounds represented by the general formulae (1) to (13) has a singlet energy gap of 2.9 to 3.9 eV and preferably 2.9 to 3.6 eV.

The organic EL device of the present invention comprises a cathode, an anode and one or more organic thin film layers having at least a light emitting layer which are sandwiched between the cathode and the anode, wherein the organic thin film layers comprises at least one layer containing the material for organic electroluminescent devices which is made of any of the compounds represented by the general formulae (1) to (13).

Also, in the organic EL device of the present invention, the light emitting layer, electron transporting layer and hole transporting layer preferably contain the material for organic EL devices which is made of any of the compounds represented by the above general formulae (1) to (13).

The organic EL device of the present invention emits a bluish light having a high color purity ranging from (0.20, 0.38) to (0.26, 0.39) in a chromaticity coordinate. This is because the material for organic EL devices which is made of any of the compounds represented by the above general formulae (1) to (13) has a broad energy gap.

The organic EL device of the present invention preferably emits light by triplet or more multiplet excitation.

The material for organic EL devices according to the present invention is preferably a host material of the organic EL device. The host material means a material capable of injecting holes and electrons thereinto and transporting the holes and electrons therethrough, and having a function of emitting a fluorescent light by recombination between the holes and electrons.

In addition, the compounds represented by the above general formulae (1) to (13) which are used in the present invention have a singlet energy gap as high as 2.9 to 3.9 eV as well as a triplet energy gap as high as 2.5 to 3.3 eV and is, therefore , suitable as an organic host material for phosphorescent devices.

The phosphorescent device used herein means such an organic electroluminescent device utilizing a so-called phosphorescent light which contains such substances having a higher intensity of emitted light based on the transition from a triplet energy level to a ground singlet energy level than that of other substances, for example, phosphorescent substances such as organic metal complexes containing at least one metal selected from the group consisting of those metals belonging to Groups 7 to 11 of the Periodic Table.

Molecular excitons (excited particles) generated in the light emitting layer of the organic EL device is in the form of a mixture containing singlet excitons and triplet excitons. In general, the singlet and triplet excitons are generated at a ratio of 1:3, namely, the triplet excitons are generated in a larger amount than the singlet excitons. In addition, in the organic EL device utilizing an ordinary fluorescence, the singlet excitons contribute to light emission, and the triplet excitons are not light emissive. Therefore, the triplet excitons are finally consumed in the form of heat, and the light emission depends upon the singlet excitons generated at a low rate. For this reason, in the organic EL device, among energy generated by the recombination of the holes and electrons, the energy shifted to production of the triplet excitons constitutes a large loss.

On the contrary, in the present invention, by utilizing the above compounds in the phosphorescent device, the energy of the triplet excitons can contribute to light emission. As a result, it is considered that the current efficiency obtained from the organic EL device of the present invention is three times that obtained from devices utilizing a fluorescence. Further, it is considered that the compounds of the present invention, when applied to the light emitting layer of the phosphorescent device, exhibits a higher excitation triplet energy level than that of the phosphorescent organic metal complexes containing the metal selected from the group consisting of those metals belonging to Groups 7 to 11 of the Periodic Table which are contained in the light emitting layer; provides a further stable thin film shape; has a high glass transition temperature Tg ranging from 80 to 160°C; is capable of efficiently transporting the holes and electrons; shows a good electrochemical or chemical stability; and is free from generation of impurities which will tend to cause traps or to quench light emission upon production or use.

The organic EL device of the present invention includes the one or more organic thin film layers sandwiched between the anode and cathode as described above. In the organic EL device of a single layer type, the light emitting layer is disposed between the anode and cathode. The light emitting layer may contain, in addition to the light-emitting material, a hole injecting material or an electron injecting material which serves for transporting the holes injected from the anode or the electrons injected from the cathode to the light emitting material. In addition, the light emitting material preferably exhibits a considerably high fluorescent quantum efficiency as well as a high hole transportability and a high electron transportability, and forms a uniform thin film. Examples of the organic EL device of a multilayer type include those having multilayer structures such as (an anode/a hole transporting layer/a light emitting layer/a cathode), (an anode/a light emitting layer/an electron transporting layer/a cathode), (an anode/a hole transporting layer /a light emitting layer/an electron transporting layer/a cathode) and (an anode/a hole transporting layer /a light emitting layer/a hole barrier layer/an electron transporting layer/a cathode).

The light emitting layer may further contain, in addition to any of the compounds represented by the above general formulae (1) to (13), conventionally known host materials, light emitting materials, doping materials, hole transporting materials or electron transporting materials, or combinations thereof according to requirements. The organic EL device having such a multilayer structure can be prevented from suffering from deterioration in luminance and lifetime due to quenching, and improved in luminance and current efficiency by using other doping materials therein, or improved in luminance and current efficiency of conventional devices by using other doping materials capable of contributing to phosphorescent light emission in combination therewith.

Further, in the organic EL device of the present invention, the hole transporting layer, the light emitting layer and the electron transporting layer may respectively have a multilayer structure including two or more layers. In this case, the hole transporting layer may include a hole injecting layer into which holes are injected from the electrode, as well as the layer for accepting the holes from the hole injecting layer and transporting the holes to the light emitting layer. Also, the electron transporting layer may include an electron injecting layer into which electrons are injected from the electrode, as well as the layer for accepting the electrons from the electron injecting layer and transporting the electrons to the light emitting layer. These respective layers may be selectively used according to respective factors such as energy level of the materials used, heat resistance and adhesion to the organic thin film layers or the metal electrodes.

In the organic EL device of the present invention, the electron transporting layer or the hole transporting layer may contain the material for organic EL devices according to the present invention which is made of any of the compounds represented by the above general formulae (1) to (13). Further, the hole injecting layer, the electron injecting layer or the hole barrier layer may contain the material for organic EL devices according to the present invention. In these layers, the material for organic EL devices according to the present invention may be used in the form of a mixture with phosphorescent compounds.

Examples of the light emitting material or the host material that is usable in the organic thin film layers together with any of the compounds represented by the above general formulae (1) to (13) according to the present invention include anthracene, naphthalene, phenanthrene, pyrene, tetracene, coronene, chrysene, fluoresceine, perylene, phthaloperylene, naphthaloperylene, perynone, phthaloperynone, naphthaloperynone, diphenyl butadiene, tetraphenyl butadiene, coumarin, oxadiazole, aldazine, bisbenzoxazoline, bisstyryl, pyrazine, cyclopentadiene, quinoline metal complexes, aminoquinoline metal complexes, benzoquinoline metal complexes, imines, diphenyl ethylene, vinyl anthracene, diaminoanthracene, diaminocarbazole, pyrane, thiopyrane, polymethine, merocyanine, imidazole-chelated oxinoid compounds, quinacridone, rubrene, stilbene-based derivatives and fluorescent dyes, though not particularly limited thereto.

The light emitting material is preferably made of a phosphorescent organic metal complex in view of further improving an external quantum efficiency of the device. Examples of the metal atom contained in the organic metal complex include ruthenium, rhodium, palladium, silver, rhenium, osmium, iridium, platinum and gold. These organic metal complexes are preferably compounds represented by the following general formula (i): 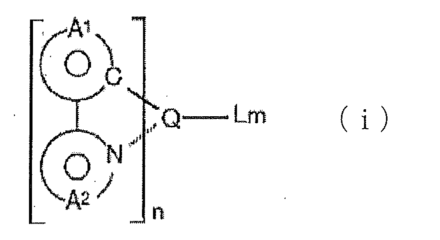 wherein A¹ represents a substituted or unsubstituted aromatic hydrocarbon ring group or aromatic heterocyclic group and preferably phenyl group, biphenyl group, naphthyl group, anthryl group, thienyl group, pyridyl group, quinolyl group or isoquinolyl group, which may be substituted with a halogen atom such as fluorine, an alkyl group having 1 to 30 carbon atoms such as methyl group and ethyl group, an alkenyl group such as vinyl group, an alkoxycarbonyl group having 1 to 30 carbon atoms such as methoxycarbonyl group and ethoxycarbonyl group, an alkoxyl group having 1 to 30 carbon atoms such as methoxy group and ethoxyl group, an aryloxy group such as phenoxyl group and benzyloxyl group, a dialkylamino group such as dimethylamino group and diethylamino group, an acyl group such as acetyl group, a haloalkyl group such as trifluoromethyl group, and a cyano group;
A² represents a substituted or unsubstituted aromatic heterocyclic group containing nitrogen as an atom constituting the heterocyclic ring and preferably pyridyl group, pyrimidyl group, a pyrazine group group, a triazine group, a benzothiazole group, a benzoxazole group, a benzoimidazole group, quinolyl group, isoquinolyl group, a quinoxaline group or a phenathridine group, and may be substituted with the same substituent groups as described in A¹;
The ring having the group represented by A¹ and the ring having the group represented by A² may form one condensed ring. Examples of the condensed ring include 7,8-benzoquinoline group, etc;
Q represents a metal selected from the group consisting of those metals belonging to Groups 7 to 11 of the Periodic Table and is preferably ruthenium, rhodium, palladium, silver, rhenium, osmium, iridium, platinum or gold;
L represents a bidentate ligand and is preferably selected from β-diketo type ligands such as acetyl acetonate, and pyromellitic acid; and
m and n respectively represent an integer with the proviso that when Q is a divalent metal, n = 2 and m = 0, and when Q is a trivalent metal, n = 3 and m = 0, or n = 2 and m = 1.

Specific examples of the organic metal complexes represented by the general formula (i) include the following compounds, though not particularly limited thereto.

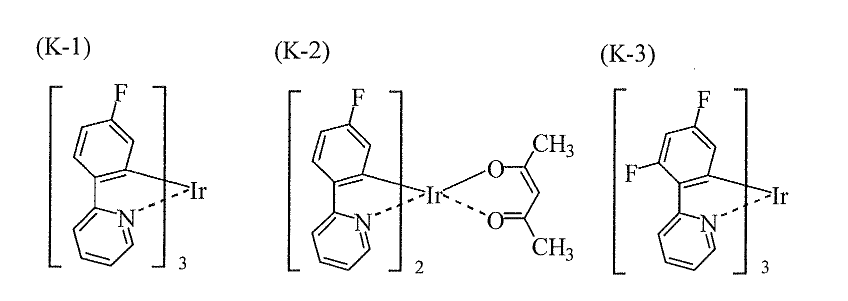

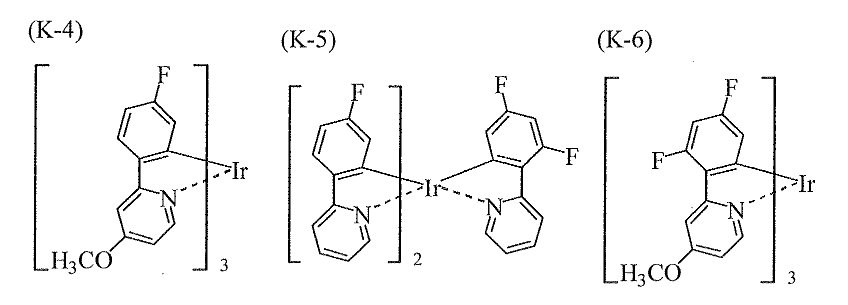

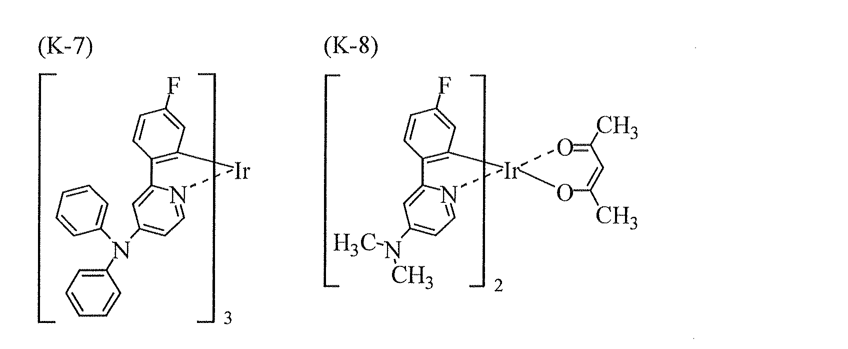

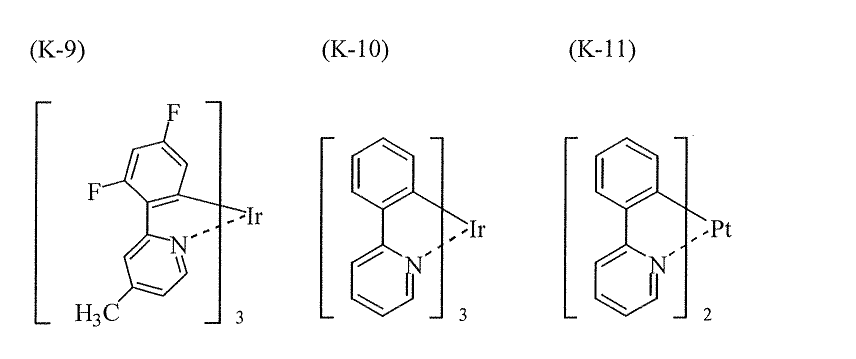

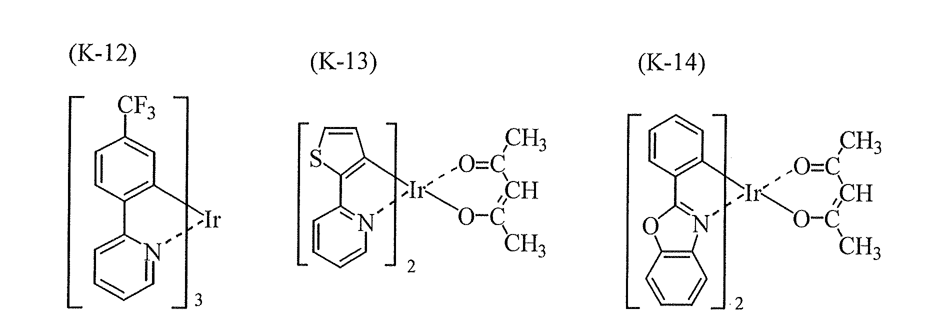

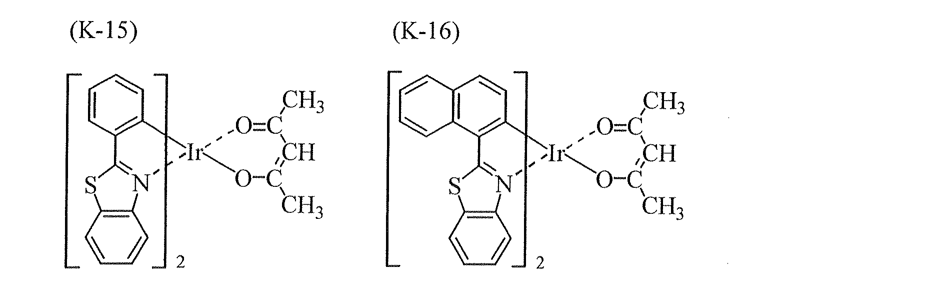

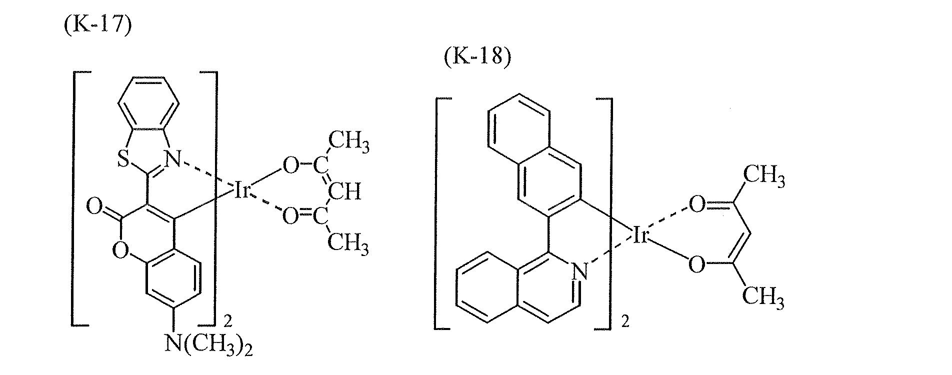

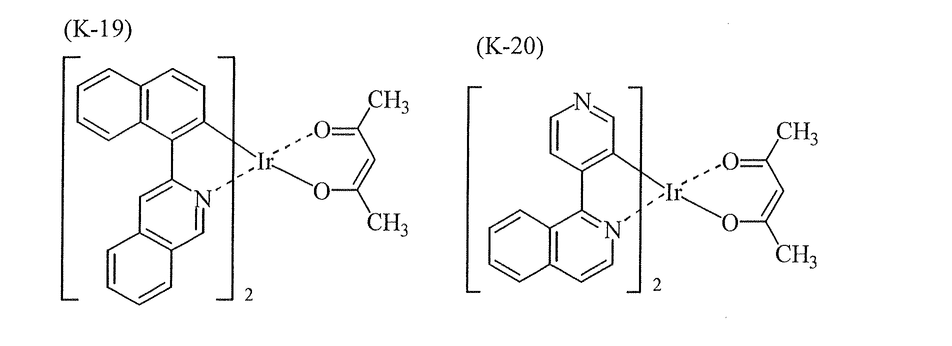

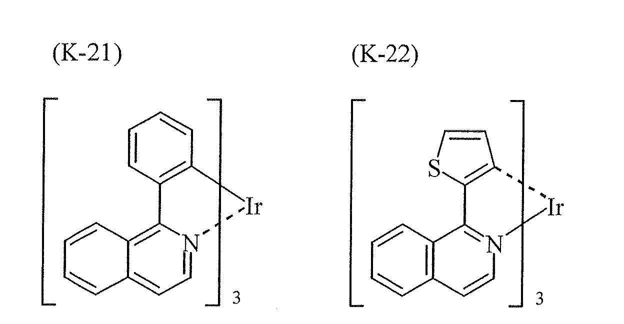

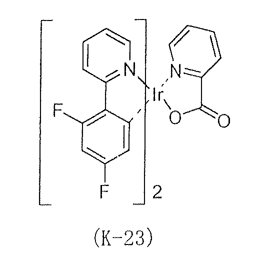

The hole injecting material is preferably made of compounds which have a good hole transportability as well as excellent capabilities of accepting holes injected from the anode and injecting the holes into the light emitting layer or light emitting material, prevent excitons generated in the light emitting layer from moving into the electron injecting layer or electron injecting material, and exhibit an excellent capability of forming a thin film. Specific examples of the hole injecting material include phthalocyanine derivatives, naphthalocyanine derivatives, porphyrin derivatives, oxazole, oxadiazole, triazole, imidazole, imidazolone, imidazole thione, pyrazoline, pyrazolone, tetrahydroimidazole, hydrazone, acyl hydrazone, polyaryl alkanes, stilbene, butadiene, benzidine-type triphenyl amine, styryl amine-type triphenyl amine, diamine-type triphenyl amine and derivatives thereof, as well as polyvinyl carbazoles, polysilanes, and high molecular materials such as conductive high molecular compounds, though not particularly limited thereto.

Of these hole injecting materials, more effective hole injecting materials are aromatic tertiary amine derivatives and phthalocyanine derivatives. Specific examples of the aromatic tertiary amine derivatives include triphenyl amine, tritolyl amine, tolyldiphenyl amine, N,N'-diphenyl-N,N'-(3-methylphenyl)-1,1'-biphenyl-4,4'-diamine, N,N,N',N'-(4-methylphenyl)-1,1'-phenyl-4,4'-diamine, N,N,N',N'-(4-methylphenyl)-1,1'-biphenyl-4,4'-diamine, N,N'-diphenyl-N,N'-dinaphthyl-1,1'-biphenyl-4,4'-diamine, N,N'-(methylphenyl)-N,N'-(4-n-butylphenyl)-phenanthrene- 9,10-diamine, N,N-bis(4-di-4-tolylaminophenyl)-4-phenyl-cylcohexane, and oligomers and polymers having these aromatic tertiary amine skeletons, though not particularly limited thereto. Specific examples of the phthalocyanine (Pc) derivatives include phthalocyanine derivatives such as H₂Pc, CuPc, CoPc, NiPc, ZnPc, PdPc, FePc, MnPc, ClAlPc, ClGaPc, ClInPc, ClSnPc, Cl₂SiPc, (HO)AlPc, (HO)GaPc, VOPc, TiOPc, MoOPc, GaPc-O-GaPc, as well as naphthalocyanine derivatives, though not particularly limited thereto.

The electron injecting material is preferably made of compounds which have a good electron transportability as well as excellent capabilities of accepting electrons injected from the anode and injecting the electrons into the light emitting layer or light emitting material, prevent excitons generated in the light emitting layer from moving into the hole injecting layer, and exhibit an excellent capability of forming a thin film. Specific examples of the electron injecting material include fluorenone, anthraquinodimethane, diphenoquinone, thiopyrane dioxide, oxazole, oxadiazole, triazole, imidazole, perylenetetracarboxylic acid, quinoxaline, fluorenylidene methane, anthrone, and derivatives thereof, though not particularly limited thereto.

Of these electron injecting materials, more effective electron injecting materials are metal complex compounds and five membered ring derivatives having nitrogen atom. Specific examples of the metal complex compounds include 8-hydroxyquinolinato lithium, bis(8-hydroxyquinolinato) zinc, bis(8-hydroxyquinolinato) copper, bis(8-hydroxyquinolinato) manganese, tris(8-hydroxyquinolinato) aluminum, tris(2-methyl-8-hydroxyquinolinato) aluminum, tris(8-hydroxyquinolinato) gallium, bis(10-hydroxybenzo[h]quinolinato) beryllium, bis(10-hydroxybenzo[h]quinolinato) zinc, bis(2-methyl-8-quinolinato) chlorogallium, bis(2-methyl-8-quinolinato) (o-cresolato) gallium, bis(2-methyl-8-quinolinato) (1-naphtholato) aluminum, and bis(2-methyl-8-quinolinate) (2-naphtholato) gallium, though not particularly limited thereto.

The five membered ring derivatives having nitrogen atom are preferably derivatives of oxazole, thiazole, oxadiazole, thiadiazole or triazole. Specific examples of the five membered ring derivatives having nitrogen atom include 2,5-bis(1-phenyl)-1,3,4-oxazole, dimethyl POPOP, 2,5-bis(1-phenyl)-1,3,4-thiazole, 2,5-bis(1-phenyl)-1,3,4-oxadiazole, 2-(4'-tert-butylphenyl)-5-(4"-biphenyl)-1,3,4-oxadiazole, 2,5-bis(1-naphthyl)-1,3,4-oxadiazole, 1,4-bis[2-(5-phenyloxadiazolyl)]benzene, 1,4-bis[2-(5-phenyloxadiazolyl)-4-tert-butylbenzene], 2-(4'-tert-butylphenyl)-5-(4"-biphenyl)-1,3,4-thiadiazole, 2,5-bis(1-naphthyl)-1,3,4-thiadiazole, 1,4-bis[2-(5-phenylthiadiazolyl)]benzene, 2-(4'-tert-butylphenyl)-5-(4"-biphenyl)-1,3,4-triazole, 2,5-bis(1-naphthyl)-1,3,4-triazole, and 1,4-bis[2-(5-phenyltriazolyl)]benzene, though not particularly limited thereto.

In addition, an electron accepting substance and an electron donating substance may be added to the hole injecting material and the electron injecting material, respectively, to enhance an electron injecting property of the organic EL device.

The anode of the organic EL device according to the present invention may be suitably made of an electrically conductive material having a work function of more than 4 eV. Examples of the conductive material for the anode include carbon, aluminum, vanadium, iron, cobalt, nickel, tungsten, silver, gold, platinum, palladium and alloys thereof, metal oxides such as tin oxide and indium oxide which are applied to ITO substrates or NESA substrates, and organic conductive resins such as polythiophene and polypyrrole. The cathode of the organic EL device according to the present invention may be suitably made of an electrically conductive material having a work function of less than 4 eV. Examples of the conductive material for the cathode include magnesium, calcium, tin, lead, titanium, yttrium, lithium, ruthenium, manganese, aluminum and alloys thereof, though not particularly limited thereto. Typical examples of the alloys include alloys of magnesium and silver, alloys of magnesium and indium, and alloys of lithium and aluminum, though not particularly limited thereto. The ratio between the constituting metals in the alloys may be controlled and appropriately determined depending upon temperature of vapor deposition sources, atmosphere, vacuum degree, etc. The anode and cathode may be constituted of two or more layers, if required.

The organic EL device of the present invention may further comprise an inorganic compound layer between at least one of the electrodes and the organic thin film layers. Examples of inorganic compounds suitably used in the inorganic compound layer include alkali metal oxides, alkali earth metal oxides, rare earth oxides, alkali metal halides, alkali earth metal halides, rare earth halides, various oxides, nitrides and oxide nitrides such as SiOₓ, AlOₓ, SiNₓ, SiON, AlON, GeOₓ, LiOₓ, LiON, TiOₓ, TiON, TaOₓ, TaON and TaOₓ, and C. In particular, a portion of the inorganic compound layer which comes into contact with the anode is preferably made of SiOₓ, AlOₓ, SiNₓ, SiON, AlON, GeOₓ, or C since these substances can suitably form a stable injection boundary layer. Further, a portion of the inorganic compound layer which comes into contact with the cathode is preferably made of LiF, MgF₂, CaF₂, MgF₂ or NaF.

At least one surface of the organic EL device of the present invention preferably exhibits a sufficient transparency in a wavelength range of light emission therefrom in order to enhance a current efficiency thereof. Further, the substrate for the device is also preferably transparent.

The transparent electrode is formed using the above electrically conductive material by vapor deposition method, sputtering method, etc., so as to ensure a desirable transparency thereof. The electrode disposed on a light emitting surface of the device preferably has a light transmittance of 10% or more. The substrate is not particularly limited as long as it suitably has a good mechanical and thermal strength as well as a good transparency. Of these substrates, preferred are glass substrates and transparent resin films. Examples of the transparent resin films include films made of polyethylene, ethylene-vinyl acetate copolymer, ethylene-vinyl alcohol copolymer, polypropylene, polystyrene, polymethyl methacrylate, polyvinyl chloride, polyvinyl alcohol, polyvinyl butyral, nylons, polyether ether ketones, polysulfones, polyether sulfones, tetrafluoroethylene-perfluoroalkylvinyl ether copolymer, polyvinyl fluoride, tetrafluoroethylene-ethylene copolymer, tetrafluororethylene-hexafluoropropylene copolymer, polychlorotrifluoroethylene, polyvinylidene fluoride, polyesters, polycarbonates, polyurethanes, polyimides, polyether imides, etc.

The organic EL device of the present invention may be further provided on a surface thereof with a protective layer, or the whole part thereof may be protected with silicone oil, resins, etc., in order to enhance a stability thereof against temperature, humidity, atmosphere, etc.

The respective layers of the organic EL device of the present invention may be formed by either a dry film-forming method such as vacuum deposition, sputtering, plasma and ion-plating, or a wet film-forming method such as spin-coating, dipping and flow-coating. The thickness of the respective layers is not particularly limited, but should be adjusted to an appropriate range. If the thickness is too large, a large electric voltage must be applied to the device in order to achieve a predetermined light output, resulting in a poor current efficiency. On the other hand, if the thickness is too small, pinholes tend to be formed in the layers, thereby failing to a sufficient luminance even upon applying an electric field thereto. The suitable thickness of the respective layers is usually in the range of 5 nm to 10 µm and preferably 10 nm to 0.2 µm.

In the wet film-forming method, materials for the respective layers are dissolved in a suitable solvent such as ethanol, chloroform, tetrahydrofuran and dioxane to form a thin film thereof. The solvent used for forming the respective layers is not particularly limited. Also, suitable resins or additives may be added to the respective layers for the purposes of improving a film-forming property, preventing formation of pinholes in the resultant film, etc. Examples of the resins usable for the above purposes include insulating resins such as polystyrene, polycarbonates, polyarylates, polyesters, polyamides, polyurethanes, polysulfones, polymethyl methacrylate, polymethyl acrylate and celluloses as well as copolymers thereof, photoconductive resins such as poly-N-vinyl carbazole and polysilanes, and conductive resins such as polythiophene and polypyrrole. Examples of the additives include antioxidants, ultraviolet absorbers and plasticizers.

As described above, when using the material for organic EL devices according to the present invention which is made of any of the compounds represented by the general formulae (1) to (13), it is possible to obtain an organic EL device having a high color purity. The organic EL device may be suitably applied to, for example, flat panel light-emitting members such as electrophotographic materials, a wall-hanging type flat panel TV displays, and so on, copiers, printers, back light for liquid crystal displays, light sources for measuring equipments, display panels, marker light, accessories, etc.

The present invention will be described in more detail by reference to the following synthesis examples and examples. However, it should be noted that these examples are only illustrative and not intended to limit the invention thereto.

Meanwhile, a triplet energy and a singlet energy of the respective compounds were measured by the following methods.

### (1) Measurement of Triplet Energy

A minimum excitation triplet energy level Tl was measured. That is, a phosphorescent spectrum of a sample was measured (10 µmol/L EPA solution (diethyl ether: isopentane: ethanol = 5:5:2 at volume ratio); 77k, quartz cell "FLUOROLO GII" available from SPEX Inc.). A tangent was drawn at a rise-up portion of the phosphorescent spectrum curve on a short-wavelength side thereof to obtain a wavelength (light emitting end) at an intersection point between the tangent and an abscissa of the spectrum curve. The thus obtained wavelength was converted into an energy value.

### (2) Measurement of Singlet Energy (Energy Gap)

An excitation singlet energy value was measured. That is, a toluene solution containing 10⁻⁵ mol/L of a sample was subjected to measurement of an absorption spectrum thereof by using an ultraviolet/visible absorptiometer available from Hitachi Limited. A tangent was drawn at a rise-up portion of the spectrum curve on a long-wavelength side thereof to obtain a wavelength (absorption end) at an intersection point between the tangent and an abscissa of the spectrum curve. The thus obtained wavelength was converted into an energy value.

### SYNTHESIS EXAMPLE 1: Synthesis of Compound (A1)

A reaction scheme of synthesis of a compound (A1) is shown below.

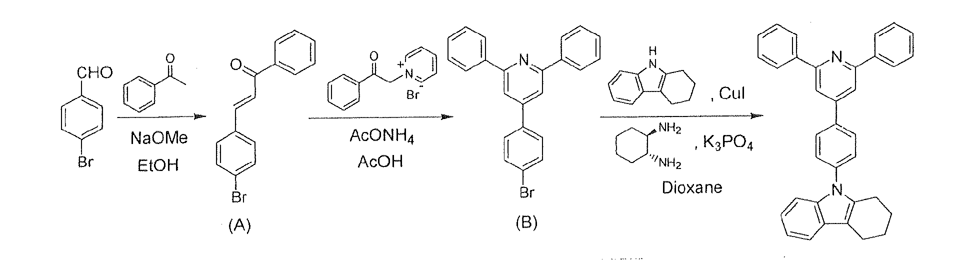

### (1) Synthesis of Intermediate Product (A)

Fifteen grams (81 mmol) of 4-bromobenzaldehyde and 9.7 g (81 mmol) of acetophenone were dissolved in 300 mL of ethanol. The resultant solution was mixed with 16.6 mL (81 mmol) of a 28% sodium methoxide methanol solution, and stirred at room temperature for 9 hours. After completion of the reaction, the precipitated crystals were separated by filtration and washed with ethanol, thereby obtaining 19.6 g of an intermediate product (A) (yield: 84%).

### (2) Synthesis of Intermediate Product (B)

Nine grams (31 mmol) of the obtained intermediate product (A), 8.7 g (31 mmol) of 1-phenathyl pyridinium bromide and 19.3 g (250 mmol) of ammonium acetate were suspended in 27 mL of acetic acid, and the resultant suspension was refluxed under heating for 12 hours. The obtained reaction solution was cooled to room temperature, and then mixed with toluene and water to separate the solution into two layers. The resultant organic layer as separated was successively washed with a 100% sodium hydroxide aqueous solution and a saturated brine, and then dried with anhydrous sodium sulfate. After distilling off the organic solvent under reduced pressure, the reaction mixture was mixed with 27 mL of ethanol, and the resultant precipitated crystals were separated by filtration and then washed with ethanol, thereby obtaining 10.6 g of an intermediate product (B) (yield: 88%).

### (3) Synthesis of Aimed Compound (A)

The obtained intermediate product (B) in an amount of 3.5 g (9 mmol) together with 1.7 g (10mmol) of 1,2,3,4-tetrahydrocarbazole, 0.09 g(0.5 mmol) of copper iodide and 4.0 g (19 mmol) of potassium phosphate were suspended in 18 mL of 1,4-dioxane, and then mixed with 0.5 mL (4 mmol) of trans-1,2-cyclohexane diamine. The resultant suspension was refluxed under heating in an argon atmosphere for 18 hours. The reaction solution was cooled to room temperature, and mixed with methylene chloride and water to separate the solution into two layers. The resultant organic layer as separated was successively washed with a 5% hydrochloric acid aqueous solution and water, and then dried with anhydrous sodium sulfate. After distilling off the organic solvent under reduced pressure, the reaction mixture was mixed with 7 mL of ethyl acetate, and the resultant precipitated crystals were separated by filtration and then washed with ethyl acetate, thereby obtaining 2.2 g of crystals (yield: 52%).

As a result of ¹H-NMR analysis (90 MHz) and Field Desorption Mass Spectrometry (FD-MS), it was confirmed that the thus obtained crystals were the aimed compound (A1). Also, the results of FD-MS are shown below.
FD-MS, calculated for C₃₅H₂₈N₂ = 476; found, m/z = 476 (M⁺, 100)

Further, it was confirmed that the obtained compound exhibited a singlet energy of 3.3 eV and a triplet energy of 2.8 eV.

### SYNTHESIS EXAMPLE 2: Synthesis of Compound (A45)

A reaction scheme of synthesis of a compound (A45) is shown below.

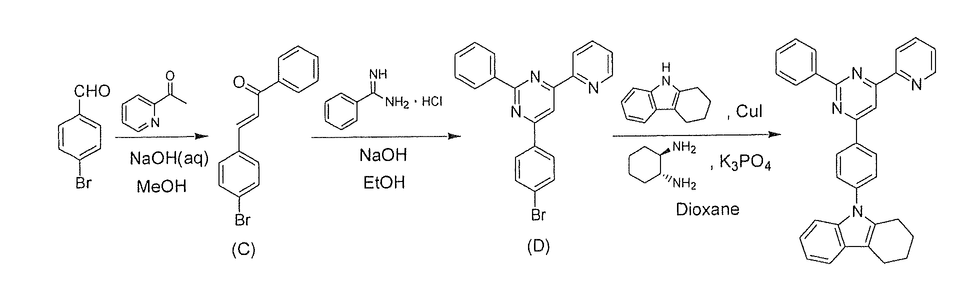

### (1) Synthesis of Intermediate Product (C)

Fifteen grams (81 mmol) of 4-bromobenzaldehyde and 10.3 g (85 mmol) of 2-acetyl pyridine were dissolved in 182 mL of methanol. Into the resultant solution was dropped 61 mL (61 mmol) of a 1M sodium hydroxide aqueous solution , and the resultant mixture was stirred at room temperature for 30 minutes. After completion of the reaction, the precipitated crystals were separated by filtration and washed with methanol, thereby obtaining 19.8 g of an intermediate product (C) (yield: 85%).

### (2) Synthesis of Intermediate Product (D)

Ten grams (35 mmol) of the obtained intermediate product (C) and 5.5 g (35 mmol) of benzamidine hydrochloride were suspended in 75 mL of ethanol. The resultant suspension was mixed with 2.8 g (70 mmol) of sodium hydroxide and then refluxed under heating for 18 hours. The obtained reaction solution was cooled to room temperature, mixed with 50 mL of water, and then stirred for 1 h. The resultant precipitated crystals were separated by filtration and then washed with ethanol, thereby obtaining 6.0 g of an intermediate product (D) (yield: 44%).

### (3) Synthesis of Aimed Compound (A45)

The same procedure as in SYNTHESIS EXAMPLE 1(3) was repeated except for using the intermediate product (D) instead of the intermediate product (B), thereby obtaining 1.9 g of crystals (yield: 44%).

As a result of ¹H-NMR analysis (90 MHz) and FD-MS, it was confirmed that the thus obtained crystals were the aimed compound (A45). Also, the results of FD-MS are shown below.
FD-MS, calculated for C₃₃H₂₆N₄ = 478; found, m/z = 478 (M⁺, 100)

Further, it was confirmed that the obtained compound exhibited a singlet energy of 3.1 eV and a triplet energy of 2.8 eV.

### SYNTHESIS EXAMPLE 3: Synthesis of Compound (A4)

A reaction scheme of synthesis of a compound (A4) is shown below.

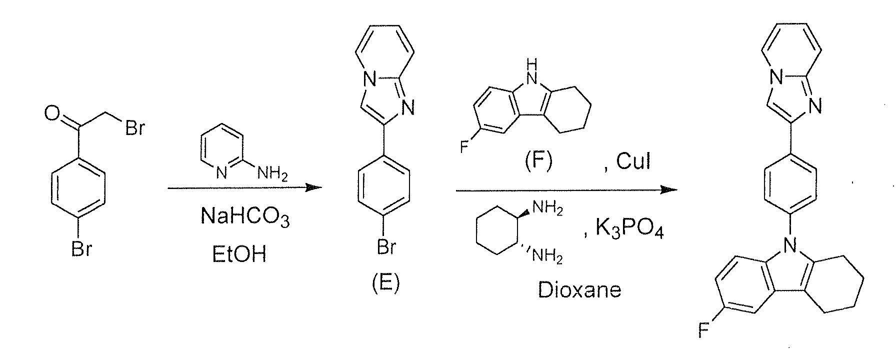

### (1) Synthesis of Intermediate Product (E)

Fifteen grams (54 mmol) of 2,4'-dibromoacetophenone and 5.2 g (55 mmol) of 2-aminopyridine were suspended in 100 mL of ethanol. The resultant suspension was mixed with 7.0 g (83 mmol) of sodium hydrogencarbonate, and then refluxed under heating for 9 hours. After cooling the reaction solution to room temperature, precipitated crystals were separated by filtration, and then successively washed with water and ethanol, thereby obtaining 12.5 g of an intermediate product (E) (yield: 85%).

### (2) Synthesis of Intermediate Product (F)

Ten grams (62 mmol) of 4-fluorophenylhydrazine hydrochloride was suspended in 46 mL of acetic acid. The resultant suspension was mixed with 7.7 mL (74 mmol) of cyclohexanone and then heated to 90°C. After 3 minutes, vigorous refluxing of the suspension was initiated, and then the reaction solution was taken out of an oil bath and stirred for 20 minutes. Thereafter, the reaction solution was further stirred at 90°C for 30 minutes and then refluxed under heating for 2 hours. The obtained reaction solution was cooled to room temperature, and then mixed with 50 mL of water. The resultant precipitated crystals were separated by filtration and then successively washed with water and ethanol, thereby obtaining 10.2 g of an intermediate product (F) (yield: 88%).

### (3) Synthesis of Aimed Compound (A4)

The same procedure as in SYNTHESIS EXAMPLE 1(3) was repeated except for using the intermediate product (E) instead of the intermediate product (B) and using the intermediate product (F) instead of 1,2,3,4-tetrahydrocarbazole, thereby obtaining 3.1 g of crystals (yield: 73%).

As a result of ¹H-NMR analysis (90 MHz) and FD-MS, it was confirmed that the thus obtained crystals were the aimed compound (A4). Also, the results of FD-MS are shown below.
FD-MS, calculated for C₂₅H₂₀FN₃ = 381; found, m/z = 381 (M⁺, 100)

Further, it was confirmed that the obtained compound exhibited a singlet energy of 3.3 eV and a triplet energy of 2.8 eV.

### SYNTHESIS EXAMPLE 4: Synthesis of Compound (A35)

A reaction scheme of synthesis of a compound (A35) is shown below.

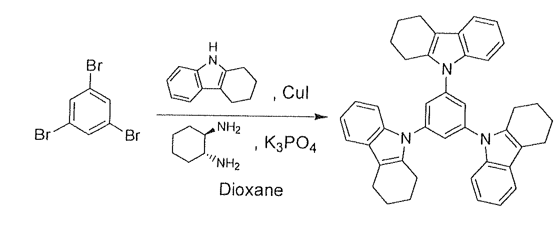

Five grams (16 mmol) of 1,3,5-tribromobenzene, 8.2 g (48 mmol) of 1,2,3,4-tetrahydrocarbazole, 0.3 g (0.4 mmol) of copper iodide and 13.8 g (65 mmol) of potassium phosphate were suspended in 50 mL of 1,4-dioxane. The resultant suspension was mixed with 1.9 mL (16 mmol) of trans-1,2-cyclohexane diamine, and then refluxed under heating in an argon atmosphere for 19 hours. The reaction solution was cooled to room temperature, and then mixed with methylene chloride and water to separate the solution into two layers. The organic layer thus separated was washed with water and then dried with anhydrous sodium sulfate. After distilling off the organic solvent from the reaction solution, 25 mL of ethyl acetate was added thereto. The resultant precipitated crystals were separated by filtration, and then washed with ethyl acetate, thereby obtaining 2.5 g of crystals (yield: 27%).

As a result of ¹H-NMR analysis (90 MHz) and FD-MS, it was confirmed that the thus obtained crystals were the aimed compound (A35). Also, the results of FD-MS are shown below.
FD-MS, calculated for C₄₂H₃₉N₃ = 585; found, m/z = 585 (M⁺, 100)

Further, it was confirmed that the obtained compound exhibited a singlet energy of 3.8 eV and a triplet energy of 3.1 eV.

### SYNTHESIS EXAMPLE 5: Synthesis of Compound (A46)

A reaction scheme of synthesis of a compound (A46) is shown below.

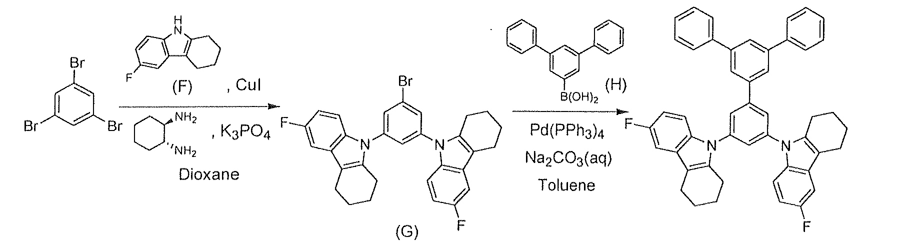

### (1) Synthesis of Intermediate Product (G)

Five grams (16 mmol) of 1,3,5-tribromobenzene, 7.5 g of the intermediate product (F) obtained in SYNTHESIS EXAMPLE 3(2), 0.3 g (0.4 mmol) of copper iodide and 13.8 g (65 mmol) of potassium phosphate were suspended in 50 mL of 1,4-dioxane. The resultant suspension was mixed with 1.9 mL (16 mmol) of trans-1,2-cyclohexane diamine, and then refluxed under heating in an argon atmosphere for 14 hours. The reaction solution was cooled to room temperature, and then mixed with methylene chloride and water to separate the solution into two layers. The organic layer thus separated was washed with water and then dried with anhydrous sodium sulfate. After distilling off the organic solvent, the reaction solution was purified by silica gel column chromatography, thereby obtaining 2.1 g of an intermediate product (G) (yield: 24%).

### (2) Synthesis of Intermediate Product (H)

Ten grams (32 mmol) of bromo-3,5-diphenylbenzene was dissolved in 50 mL of toluene and 50 mL of ether. The resultant solution was mixed with 27 mL (42 mmol) of a 1.6M n-butyl lithium hexane solution at a temperature of -16 to -42°C in an argon atmosphere, and then stirred while raising the temperature from -42 to 0°C for 1 hour. Next, the reaction solution was cooled to -70°C, and then a solution prepared by diluting 22 mL (97 mmol) of triisopropyl borate in 25 mL of ether was dropped thereinto. The resultant solution was stirred at -70°C for 1 h, and then heated to room temperature, followed by stirring for 6 hours. Further, after dropping 70 mL of a 5% hydrochloric acid solution, the reaction solution was stirred at room temperature for 45 minutes. After separating the reaction solution into two layers, the organic layer thus separated was washed with a saturated brine, and then dried with anhydrous sodium sulfate. After distilling off about one-fifth of the organic solvent under reduced pressure, the reaction solution was mixed with 10 mL of n-hexane. The resultant precipitated crystals were separated by filtration and then successively washed with a mixed solvent of toluene and n-hexane and with n-hexane, thereby obtaining 7.0 g of an intermediate product (H) (yield: 78%).

### (3) Synthesis of Aimed Compound (A46)

The same procedure as in SYNTHESIS EXAMPLE 3(3) was repeated except for using the intermediate product (G) instead of the intermediate product (E) and using the intermediate product (H) instead of the intermediate product (F), thereby obtaining 1.9 g of crystals (yield: 72%).

As a result of ¹H-NMR analysis (90 MHz) and FD-MS, it was confirmed that the thus obtained crystals were the aimed compound (A46). Also, the results of FD-MS are shown below.
FD-MS, calculated for C₄₈H₃₈F₂N₂ = 680; found, m/z = 680 (M⁺, 100)

Further, it was confirmed that the obtained compound exhibited a singlet energy of 3.5 eV and a triplet energy of 2.9 eV.

### SYNTHESIS EXAMPLE 6: Synthesis of Compound (C18)

A reaction scheme of synthesis of a compound (C18) is shown below.

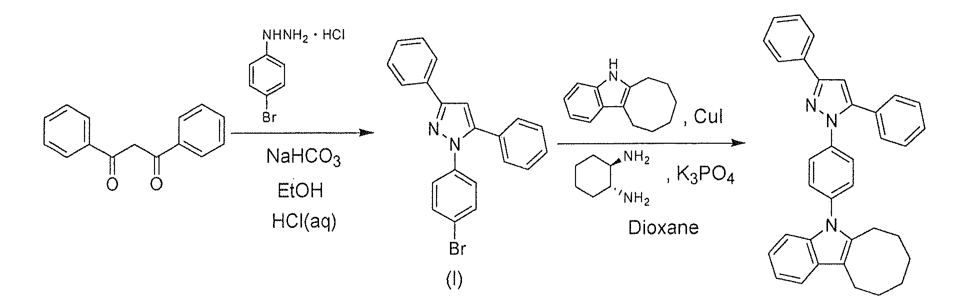

### (1) Synthesis of Intermediate Product (I)

Five grams (22 mmol) of 4-bromophenylhydrazine and 1.9 g (22 mmol) of sodium hydrogencarbonate were suspended in 100 mL of ethanol. The resultant suspension was stirred for 1 hour, mixed with 5.0 g (22 mmol) of dibenzoylmethane, and then refluxed under heating for 8 hours. Next, the obtained reaction solution was mixed with 2 mL (23 mmol) of concentrated hydrochloric acid, and then refluxed under heating for 12 hours. The resultant reaction solution was cooled to room temperature, and then mixed with 2.3 mL (23 mmol) of a 30% sodium hydroxide aqueous solution and 50 mL of water, followed by stirring for 1 hour. The resultant precipitated crystals were separated by filtration and then washed with ethanol, thereby obtaining 7.6 g of an intermediate product (I) (quantitative yield).

### (2) Synthesis of Aimed Compound (C18)

The same procedure as in SYNTHESIS EXAMPLE 1(3) was repeated except for using the intermediate product (I) instead of the intermediate product (B) and using 2,3-cyclooctenoindole instead of 1,2,3,4-tetrahydrocarbazole, thereby obtaining 1.2 g of crystals (yield: 32%).

As a result of ¹H-NMR analysis (90 MHz) and FD-MS, it was confirmed that the thus obtained crystals were the aimed compound (C18). Also, the results of FD-MS are shown below.
FD-MS, calculated for C₃₅H₃₁N₃ = 493; found, m/z = 493 (M⁺, 100)

Further, it was confirmed that the obtained compound exhibited a singlet energy of 3.4 eV and a triplet energy of 2.8 eV.

### SYNTHESIS EXAMPLE 7: Synthesis of Compound (A39)

A reaction scheme of synthesis of a compound (A39) is shown below.

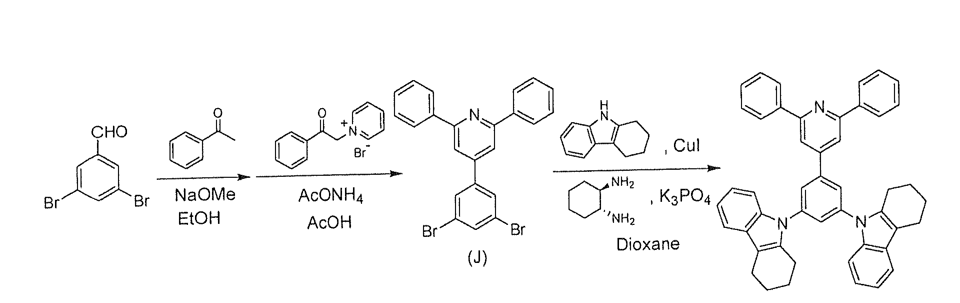

The same procedure as in SYNTHESIS EXAMPLE 1(1) was repeated except for using 3,5-dibromobenzaldehyde instead of 4-bromobenzaldehyde, thereby obtaining an intermediate product (J). The thus obtained intermediate product (J) in an amount of 2.5 g (5 mmol) together with 1.0 g (6 mmol) of 1,2,3,4-tetrahydrocarbazole, 0.05 g (0.3 mmol) of copper iodide and 2.4 g (11 mmol) of potassium phosphate were suspended in 12.5 mL of 1,4-dioxane. The resultant suspension was mixed with 0.3 mL (2 mmol) of trans-1,2-cyclohexane diamine, and then refluxed under heating in an argon atmosphere for 18 hours. The reaction solution was cooled to room temperature, and then mixed with methylene chloride and water to separate the solution into two layers. The organic layer thus separated was washed with water and then dried with anhydrous sodium sulfate. After distilling off the organic solvent from the reaction solution under reduced pressure, the obtained distillation residues were suspended in 12.5 mL of 1,4-dioxane. The resultant suspension was mixed with 0.05 g (0.3 mmol) of copper iodide, 2.4 g (11 mmol) of potassium phosphate and 0.3 mL (2 mmol) of trans-1,2-cyclohexane diamine, and then refluxed under heating in an argon atmosphere for 10 hours. Then, the reaction solution was cooled to room temperature, and then mixed with methylene chloride and water to separate the solution into two layers. The organic layer thus separated was washed with water and then dried with anhydrous sodium sulfate. After distilling off the organic solvent from the reaction solution under reduced pressure, the reaction solution was mixed with 25 mL of ethyl acetate. The resultant precipitated crystals were separated by filtration, and then washed with ethyl acetate, thereby obtaining 1.8 g of crystals (yield: 52%).

As a result of ¹H-NMR analysis (90 MHz) and FD-MS, it was confirmed that the thus obtained crystals were the aimed compound (A39). Also, the results of FD-MS are shown below.
FD-MS, calculated for C₄₇H₃₉N₃ = 645; found, m/z = 645 (M⁺, 100)

Further, it was confirmed that the obtained compound exhibited a singlet energy of 3.2 eV and a triplet energy of 2.9 eV.

### SYNTHESIS EXAMPLE 8: Synthesis of Compound (B1)

A reaction scheme of synthesis of a compound (B1) is shown below.

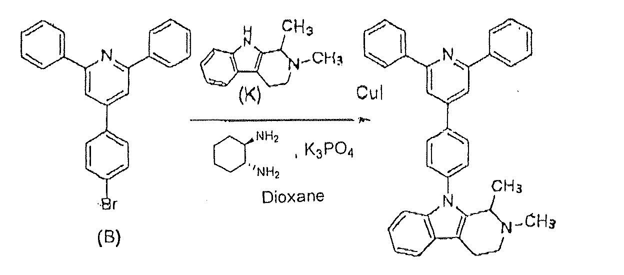

The intermediate product (B) produced by the same method as in SYNTHESIS EXAMPLE 1 in an amount of 3.5 g (9mmol) together with 2.0 g (10 mmol) of the above compound (K), 0.09 g (0.5 mmol) of copper iodide and 4.0 g (19 mmol) of potassium phosphate were suspended in 18 mL of 1,4-dioxane. The resultant suspension was mixed with 0.5 mL (4 mmol) of trans-1,2-cyclohexane diamine, and then refluxed under heating in an argon atmosphere for 18 hours. The reaction solution was cooled to room temperature, and then mixed with methylene chloride and water to separate the solution into two layers. The organic layer thus separated was successively washed with a 5% hydrochloric acid aqueous solution and water, and then dried with anhydrous sodium sulfate. After distilling off the organic solvent from the reaction solution under reduced pressure, the reaction solution was mixed with 7 mL of ethyl acetate. The resultant precipitated crystals were separated by filtration, and then washed with ethyl acetate, thereby obtaining 1.4 g of crystals (yield: 31%).

As a result of ¹H-NMR analysis (90 MHz) and FD-MS, it was confirmed that the thus obtained crystals were the aimed compound (B1). Also, the results of FD-MS are shown below.
FD-MS, calculated for C₃₅H₃₁N₃ = 505; found, m/z = 505 (M⁺, 100)

Further, it was confirmed that the obtained compound exhibited a singlet energy of 3.2 eV and a triplet energy of 2.7 eV.

### EXAMPLE 1: Preparation of Organic EL Device

A glass substrate with an ITO transparent electrode having a size of 25 mm x 75 mm x 0.7 mm in thickness which was available from Geomatic Inc., was subjected to ultrasonic cleaning in isopropyl alcohol for 5 minutes, and then to UV ozone cleaning for 30 minutes. The thus cleaned glass substrate with a transparent electrode was attached to a substrate holder of a vacuum deposition apparatus. First, a 10 nm-thick film made of the following copper phthalocyanine (CuPc film) was formed on a surface of the substrate where the transparent electrode was provided, so as to cover the transparent electrode. The thus formed CuPc film functioned as a hole injecting layer. Successively, a 30 nm-thick film made of 4,4'-bis[N-(1-naphthyl)-N-phenylamino]biphenyl (film made of the below-mentioned α-NPD) was formed on the CuPc film. The thus formed α-NPD film functioned as a hole transporting layer. Further, a 30 nm-thick light emitting layer was formed on the α-NPD film by vapor-depositing the foregoing compound (D35) on page 25 as a host material on the α-NPD film. Simultaneously with formation of the light emitting layer, Ir-bis[(4,6-difluorophenyl)-pyridinato-N, C^{2'}]picolinate (corresponding to the foregoing compound (K-23) on page 34) as a phosphorescent Ir metal complex dopant was added thereto. The content of the compound (K-23) in the light emitting layer was 7% by weight. The resultant layer functioned as a light emitting layer. Then, a 30 nm-thick film made of (1,1'-bisphenyl)-4-olato) bis(2-methyl-8-quinolinolato) aluminum (film made of the below-mentioned BALq) was formed on the light emitting layer. The thus formed BALq film functioned as a hole barrier/electron injecting combined layer. Thereafter, LiF as an alkali metal halide was vapor-deposited on the BALq film to form a 0.2 nm-thick film, and then aluminum was vapor-deposited on the LiF film to form a 150 nm-thick film. The thus formed Al:LiF film functioned as a cathode. Thus, an organic EL device was produced.

As a result of subjecting the device to electrically energizing test, it was confirmed that a blue light was emitted with a luminance of 103 cd/m² and a current density of 1.39 mA/cm² at a voltage of 7.6 V. A chromaticity coordinate thereof was (0.20, 0.38) and a current efficiency thereof was 7.40 cd/A.

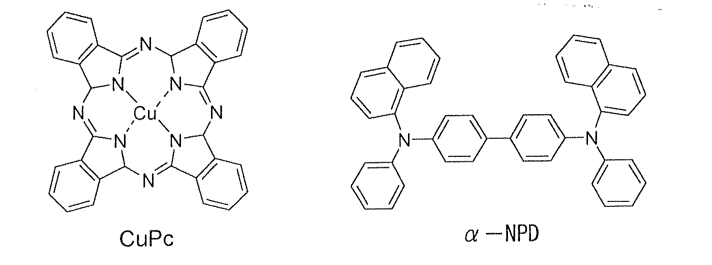

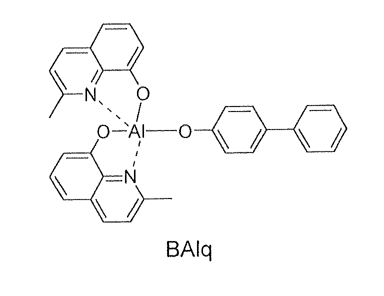

### EXAMPLE 2: Preparation of Organic EL Device

The same procedure as in EXAMPLE 1 was repeated except for using the foregoing compound (A38) on page 16 instead of the compound (D35), thereby preparing an organic EL device. The thus prepared organic EL device was subjected to measurements of voltage, current density, luminance, current efficiency, color of emitted light and color purity by the same method as above. The results are shown in Table 1.

### COMPARATIVE EXAMPLE 1: Preparation of Organic EL Device

The same procedure as in EXAMPLE 1 was repeated except for using the following compound (H1) described in U.S. Patent Application Publication No. 2002-0028329 instead of the compound (D35), thereby preparing an organic EL device. The thus prepared organic EL device was subjected to measurements of voltage, current density, luminance, current efficiency, color of emitted light and color purity by the same method as above. The results are shown in Table 1.

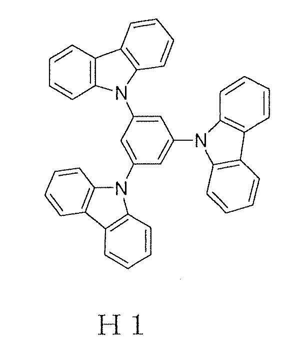

**TABLE 1-1**

| | Organic host material in light emitting layer | Voltage (V) | Current density (mA/cm²) |
|---|---|---|---|
| Example 1 | D35 | 7.6 | 1.39 |
| Example 2 | A38 | 6.8 | 1.10 |
| Comparative Example 1 | H1 | 9.1 | 2.09 |

**TABLE 1-2**

| | Luminance (cd/m²) | Current Efficiency (cd/A) | Color of emitted light | Chromaticity coordinate |
|---|---|---|---|---|
| Example 1 | 103 | 7.40 | Blue | (0.20, 0.38) |
| Example 2 | 98 | 8.94 | Blue | (0.26, 0.39) |
| Comparative Example 1 | 101 | 4.84 | Blue | (0.21, 0.38) |

As shown in Table 1, it was confirmed that the organic EL devices prepared using the compounds of the present invention was driven even at a low voltage and emitted a blue light with a high efficiency as compared to that using the conventional compound (H1) of COMPARATIVE EXAMPLE 1. Further, it was confirmed that since the compounds of the present invention exhibited a broad energy gap, luminescent molecules having a broad energy gap were mixed in the light emitting layer for light emission.

### EXAMPLE 3

The same procedure as in EXAMPLE 1 was repeated except for using the above compound (A38) instead of the compound (D35) and using the foregoing compound (K-10) on page 32 at a concentration of 5% by weight instead of the compound (K-23), thereby preparing an organic EL device. The thus prepared organic EL device was subjected to measurements of voltage, current density, luminance, current efficiency, color of emitted light and color purity by the same method as above. The results are shown in Table 2.

### EXAMPLE 4

The same procedure as in EXAMPLE 3 was repeated except for using the foregoing compound (A1) on page 14 instead of the compound (A38), thereby preparing an organic EL device. The thus prepared organic EL device was subjected to measurements of voltage, current density, luminance, current efficiency, color of emitted light and color purity by the same method as above. The results are shown in Table 2.

### COMPARATIVE EXAMPLE 2

The same procedure as in EXAMPLE 4 was repeated except for using the following compound (H2) described in Japanese Patent Application Laid-Open No, 2000-169448 instead of the compound (A1), thereby preparing an organic EL device. The thus prepared organic EL device was subjected to measurements of voltage, current density, luminance, current efficiency, color of emitted light and color purity by the same method as above. The results are shown in Table 2.

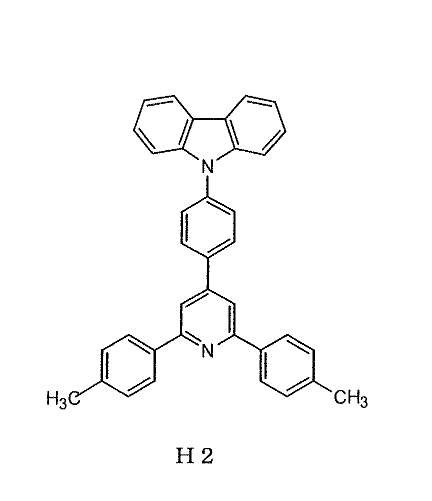

**TABLE 2-1**

| | Organic host material in light emitting layer | Voltage (V) | Current density (mA/cm²) |
|---|---|---|---|
| Example 3 | A38 | 5.4 | 0.38 |
| Example 4 | A1 | 5.8 | 0.30 |
| Comparative Example 2 | H2 | 6.3 | 0.54 |

**TABLE 2-2**

| | Luminance (cd/m²) | Current Efficiency (cd/A) | Color of emitted light | Chromaticity coordinate |
|---|---|---|---|---|
| Example 3 | 104 | 27.5 | Green | (0.32, 0.61) |
| Example 4 | 103 | 34.6 | Green | (0.33, 0.61) |
| Comparative Example 2 | 106 | 19.8 | Green | (0.32, 0.61) |

As shown in Table 2, it was confirmed that even the organic EL devices emitting a green light which were produced using the material for organic EL devices according to the present invention, were also driven at a low voltage and a high efficiency. In particular, in comparison between the compound (A1) of EXAMPLE 3 and the compound (H2) of COMPARRTIVE EXAMPLE 2, it was confirmed that although both the compounds were similar in structure to each other, compounds having such a structure of (A1) were excellent in properties required for the material for organic EL devices.

### INDUSTRIAL APPLICABILITY

As described in detail above, when the compound represented by the general formula (1) according to the present invention is used as a material for organic luminescent devices , it is possible to produce an organic luminescent device capable of operating even at a low voltage and emitting light at a high efficiency. Therefore, the organic luminescent device of the present invention is extremely useful as light sources for various electronic equipments, etc.

## Claims

1. A material for organic electroluminescent devices, comprising a compound represented by the following general formula (1): 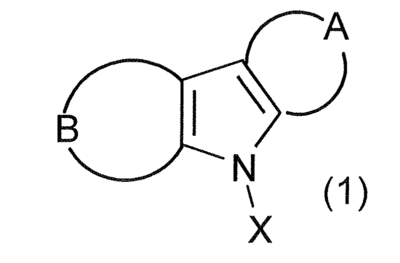 wherein A represents an alkylene group having 3 to 6 carbon atoms or an aminoalkylene group having 2 to 5 carbon atoms and containing at least one secondary or tertiary nitrogen atom, and the carbon atoms and nitrogen atom constituting a cyclic structure formed by the group represented by A may have any substituent groups;
B represents a conjugated unsaturated chain containing three kinds of atoms including carbon, hydrogen and nitrogen or two kinds of atoms including carbon and hydrogen, and the carbon atoms constituting a cyclic structure formed by the group represented by B may have any substituent groups; and
X is represented by L, L-Y or Y-L-Y wherein L is a group directly bonded to N; L represents a substituted or unsubstituted aryl group having 6 to 40 carbon atoms, a substituted or unsubstituted heterocyclic group having 3 to 40 carbon atoms, a linear or branched and substituted or unsubstituted alkyl group having 1 to 30 carbon atoms, a substituted or unsubstituted cycloalkyl group having 5 to 40 carbon atoms, a substituted or unsubstituted arylene group having 6 to 40 carbon atoms, a substituted or unsubstituted di- or more valent heterocyclic group having 3 to 40 carbon atoms, a linear or branched and substituted or unsubstituted alkylene group having 1 to 30 carbon atoms, or a substituted or unsubstituted cycloalkylene group having 5 to 40 carbon atoms; and Y represents a substituted or unsubstituted arylene group having 6 to 40 carbon atoms, a substituted or unsubstituted heterocyclic group having 3 to 40 carbon atoms, a linear or branched and substituted or unsubstituted alkyl group having 1 to 30 carbon atoms, or a substituted or unsubstituted cycloalkyl group having 5 to 40 carbon atoms.

2. The material for organic electroluminescent devices according to claim 1, wherein the compound represented by the general formula (1) is any of compounds represented by the following formulae (2) to (6): 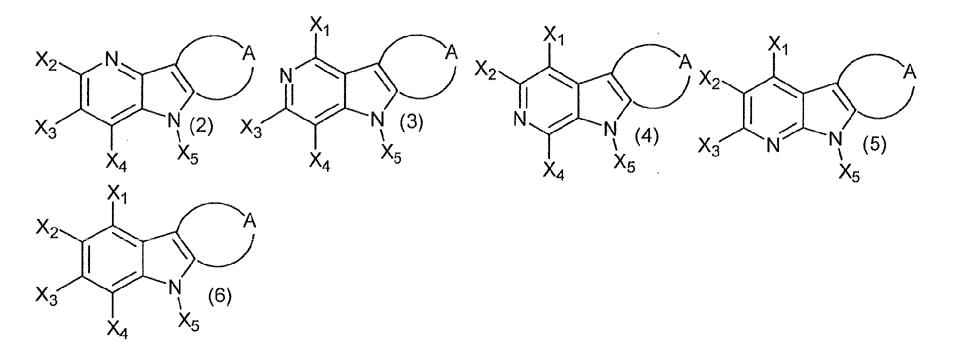 wherein A is the same as defined above; X₁ to X₅ independently represent a hydrogen atom, L, L-Y or Y-L-Y with the proviso that X₅ is not a hydrogen atom wherein L is a group directly bonded to N; and
L and Y are the same as defined above.

3. The material for organic electroluminescent devices according to claim 2, wherein the compound represented by the formula (6) is any of compounds represented by the following formulae (7) to (10): 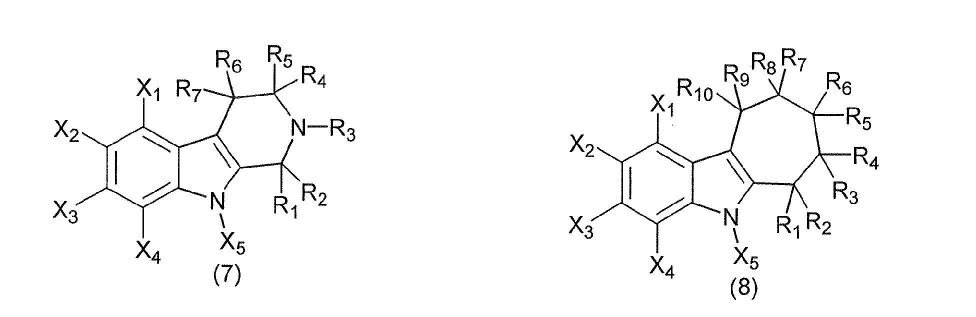 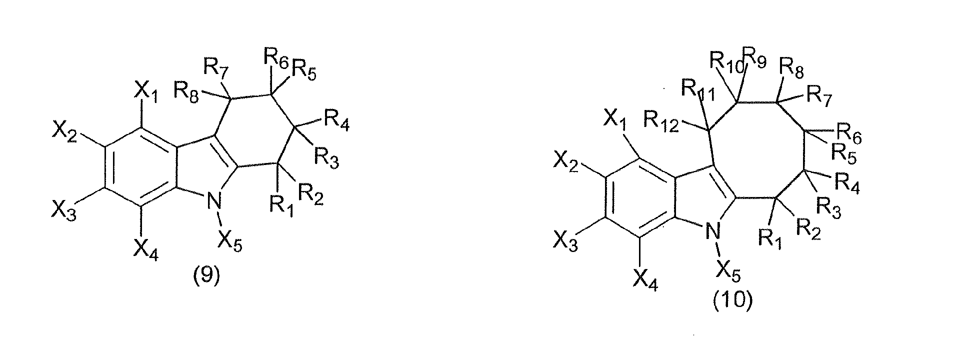 wherein X₁ to X₅ independently represent a hydrogen atom, L, L-Y or Y-L-Y with the proviso that X₅ is not a hydrogen atom wherein L is a group directly bonded to N; L and Y are the same as defined above; and
R₁ to R₁₂ independently represent a halogen atom, a cyano group, a silyl group, a substituted or unsubstituted amino group, a substituted or unsubstituted aryl group having 6 to 40 carbon atoms, a substituted or unsubstituted aryloxy group having 6 to 40 carbon atoms, a substituted or unsubstituted heterocyclic group having 3 to 40 carbon atoms, a linear or branched and substituted or unsubstituted alkyl group having 1 to 30 carbon atoms, a substituted or unsubstituted alkoxy group having 1 to 30 carbon atoms, a substituted or unsubstituted aralkyl group having 7 to 40 carbon atoms, or a substituted or unsubstituted cycloalkyl group having 5 to 40 carbon atoms.

4. The material for organic electroluminescent devices according to claim 3, wherein the compound represented by the formula (9) is any of compounds represented by the following formulae (11) to (13): 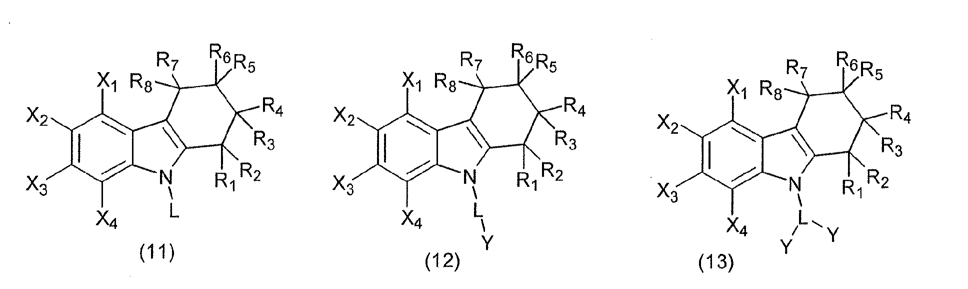 wherein X₁ to X₄ independently represent L, L-Y or Y-L-Y wherein L is a group directly bonded to N; L and Y are the same as defined above; and
R₁ to R₈ are respectively the same as defined above.

5. The material for organic electroluminescent devices according to claim 1, wherein the compound represented by the general formula (1) has a triplet energy gap of 2.5 to 3.3 eV.

6. The material for organic electroluminescent devices according to claim 1, wherein the compound represented by the general formula (1) has a singlet energy gap of 2.9 to 3.9 eV.

7. An organic electroluminescent device comprising a cathode, an anode and one or more organic thin film layers having at least a light emitting layer which are sandwiched between the cathode and the anode, wherein at least one layer in the organic thin film layers contains the material for organic electroluminescent devices as claimed in claim 1.

8. An organic electroluminescent device comprising a cathode, an anode and one or more organic thin film layers having at least a light emitting layer which are sandwiched between the cathode and the anode, wherein the light emitting layer contains the material for organic electroluminescent devices as claimed in claim 1.

9. An organic electroluminescent device comprising a cathode, an anode and one or more organic thin film layers having at least a light emitting layer which are sandwiched between the cathode and the anode, wherein the organic thin film layers comprises an electron transporting layer containing the material for organic electroluminescent devices as claimed in claim 1.

10. An organic electroluminescent device comprising a cathode, an anode and one or more organic thin film layers having at least a light emitting layer which are sandwiched between the cathode and the anode, wherein the organic thin film layers comprises a hole transporting layer containing the material for organic electroluminescent devices as claimed in claim 1.

11. The organic electroluminescent device according to claim 7 or 8, wherein said material for organic electroluminescent devices is an organic host material.

12. The organic electroluminescent device according to claim 7, further comprising an inorganic compound layer disposed between at least one of the electrodes and the organic thin film layers.

13. The organic electroluminescent device according to claim 7, wherein said organic electroluminescent device emits light by triplet or more multiplet excitation.

14. The organic electroluminescent device according to claim 7 or 8, wherein said light emitting layer contains a phosphorescent substance made of an organic metal complex containing at least one metal selected from the group consisting of those metals belonging to Groups 7 to 11 of the Periodic Table.
